# FASCICULE DE BREVET EUROPEEN

(11) **EP 3 170 214 B1**
(45) Date de publication et mention de la délivrance du brevet: **19.09.2018**
(21) Numéro de dépôt: 15754265.5
(22) Date de dépôt: 09.07.2015
(51) Int. Cl.: H01L 51/52

(54) **SUPPORT ELECTROCONDUCTEUR POUR OLED, OLED L'INCORPORANT, ET SA FABRICATION**
ELEKTRISCH LEITFÄHIGER OLED-TRÄGER, OLED DAMIT UND DESSEN HERSTELLUNG
ELECTRICALLY CONDUCTIVE OLED CARRIER, OLED INCORPORATING IT, AND ITS MANUFACTURE

(30) Priorité: 17.07.2014 FR 1456880
(43) Date de publication de la demande: 24.05.2017
(73) Titulaire: Saint-Gobain Glass France, 92400 Courbevoie (FR)
(72) Inventeur: GUIMARD, Denis, F-75013 Paris (FR); BOOZ, Julien, F-93210 Saint-Denis (FR)
(74) Mandataire: Saint-Gobain Recherche
(86) Numéro de dépôt international: PCT/FR2015/051895
(87) Numéro de publication internationale: WO 2016/009132

(56) Documents cités:
- EP-A1- 0 888 035
- EP-A1- 2 278 852
- WO-A1-2008/139934
- WO-A1-2011/089343
- GB-A- 2 289 289

## Description

La présente invention a pour objet un support électroconducteur, le dispositif électroluminescent organique l'incorporant et sa fabrication.

Les diodes électroluminescents organiques dites OLED (pour « Organic Light Emitting Diodes » en anglais) comportent classiquement un matériau ou un empilement de matériaux électroluminescents organiques alimenté en électricité par deux électrodes l'encadrant généralement sous forme de couches électroconductrices.

De manière classique, l'électrode supérieure est une couche métallique réfléchissante par exemple en aluminium, et l'électrode inférieure est une couche transparente à base d'oxyde d'indium, généralement l'oxyde d'indium dopé à l'étain plus connu sous l'abréviation ITO d'épaisseur de l'ordre de 100 à 150nm. Cependant, pour un éclairage uniforme sur de grandes surfaces, il est nécessaire de former une électrode inférieure discontinue, typiquement en formant des zones d'électrodes de quelques mm² et de réduire drastiquement la distance entre chaque zone d'électrodes, typiquement de l'ordre d'une dizaine de microns.

La demande de brevet WO2009071822 propose une électrode inférieure alternative. Plus précisément, l'électrode inférieure comporte d'abord un conducteur en grille apériodique, épais de 1µm, formé de brins irréguliers à base d'argent, de largeur moyenne A de l'ordre de 3µm, et espacées entre eux d'une distance moyenne B de l'ordre de 30µm, avec un rapport B/A de 10.

Cette grille électroconductrice est fabriquée par évaporation d'argent sur un masque doté d'un réseau d'ouvertures autoorganisées. Le masque est retiré ensuite.

De cette façon, par un choix judicieux de B/A et de l'épaisseur, la résistance carré de cette grille, particulièrement basse, est de 0,60hm/carré environ. La transmission lumineuse T_{L} de cette grille est de 70% environ et les brins sont invisibles à l'oeil nu.

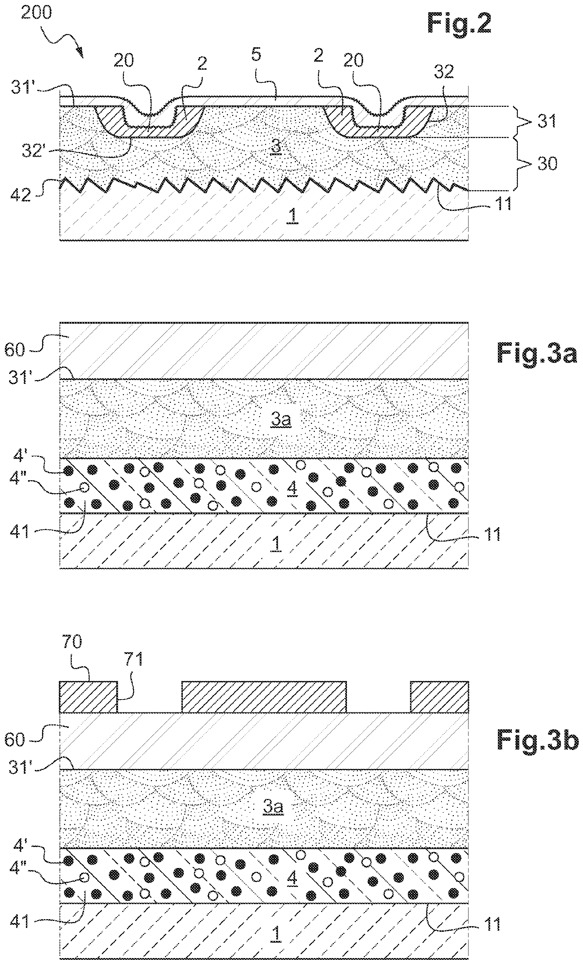

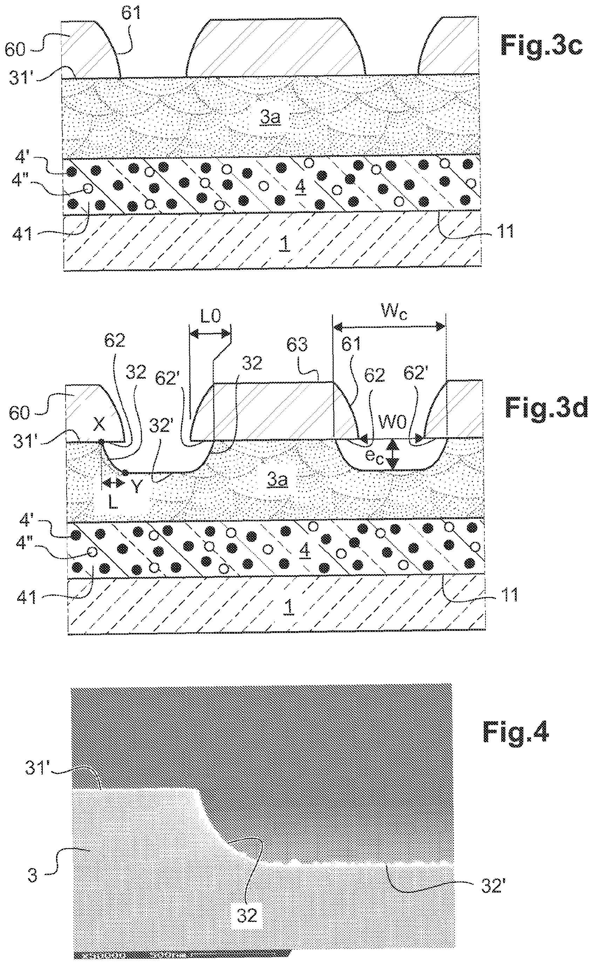

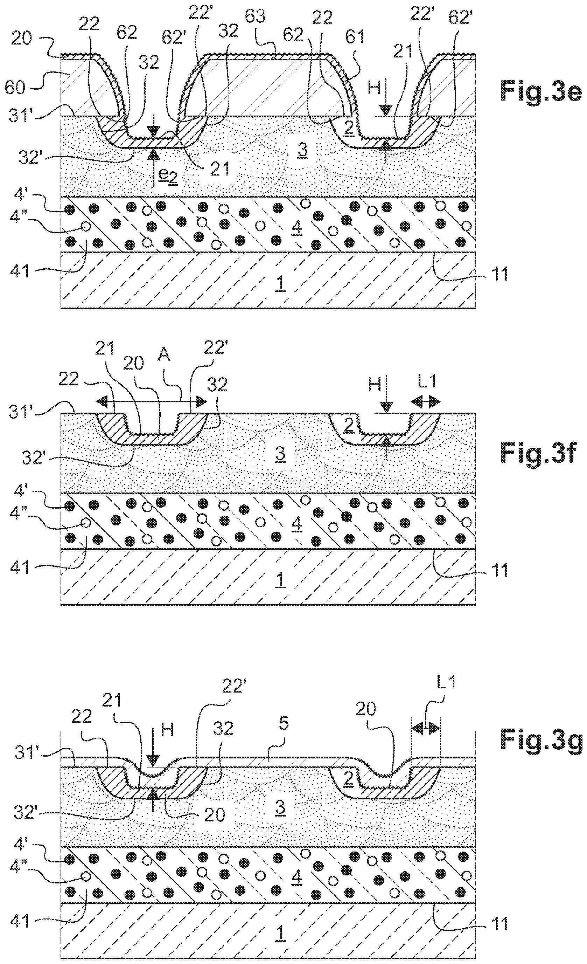

Entre les brins de grille, une couche de remplissage en fritte de verre fondue qui peut être haut indice est ajoutée, dans le mode de réalisation en relation avec la figure 3. La surface formée par les brins de la grille et de la fritte de verre fondue est lissée par polissage mécanique en employant par exemple un polissage à l'alumine ou à l'oxyde cérium. Pour la fabrication de l'électrode, on dépose de la fritte de verre entre les brins de grille et au-delà jusqu'à former une surcouche sur les brins. Après recuit, on vient ensuite araser la surface jusqu'au niveau des brins.

Un revêtement électroconducteur couvrant la grille et la couche de remplissage préserve le lissage et permet de répartir le courant. Le revêtement électroconducteur est de l'ITO déposé par pulvérisation pour obtenir une résistivité p1 de l'ordre de 10⁻⁴ Ohm.cm, avec une épaisseur à partir de 40nm ou est du PEDOT/PSS déposé par voie liquide.

La demande de brevet WO2008139934 propose aussi une électrode grille ancrée dans une couche bas indice.

La demande de brevet EP2278852 propose à l'inverse une électrode classique pleine couche sur une couche de planarisation d'une couche d'extraction donc la plus lisse possible.

La demande de brevet EP0888035 divulgue une méthode pour former un matériau métallique dans des cavités afin de réduire la résistance de l'électrode transparente, la méthode comportant:
la réalisation d'un masque discontinu sur une couche avec un arrangement d'ouvertures
traversantes donné, la gravure de la couche au travers des ouvertures traversantes du masque, et le dépôt d'un matériau métallique dans les cavités. Même si ces électrodes contribuent en outre à l'augmentation des performances globales du dispositif OLED (rendement lumineux, uniformité d'éclairage ...) ces performances peuvent être encore améliorées.

A cet effet, la présente invention un support conducteur pour OLED comportant dans cet ordre:
- un substrat verrier (transparent, éventuellement translucide notamment si texturé en surface), verre organique ou minéral d'indice de réfraction n₁ dans une gamme allant de 1,3 à 1,6, avec une première face principale, dite première surface,
- une électrode, laquelle comporte un couche arrangée en grille, dite grille métallique, en matériau(x) métallique(s) (pur ou alliage, de préférence monocouche voire multicouche) présentant une résistance par carré inférieure à 20Ω/□, mieux à 10Ω/□, la grille métallique présentant une épaisseur e2 d'au moins 100nm et de préférence d'au plus 1500nm, la grille étant formée de brins (autrement dit pistes) ayant une largeur A inférieure ou égale à 50µm, et étant séparés par une distance entre brins B inférieure ou égale 5000µm, ces brins étant séparés par une pluralité de domaines non électroconducteurs électriquement isolant d'indice de réfraction supérieur à 1,65,
le support comportant du côté de la première surface :
- une couche d'extraction de lumière, électriquement isolante, typiquement par diffusion volumique et/ou surfacique de la lumière, d'épaisseur e₀ donnée, de préférence comportant (constituée de) :
   - la première surface du substrat qui est diffusante (texturée pour être diffusante) et/ou
   - une couche additionnelle diffusante (de préférence directement) sur la première surface du substrat (plane ou texturée), de matière, de préférence (essentiellement) minérale, avec des éléments diffusants, par exemple matière qui est d'indice de réfraction n₄ de 1,7 à 2,3 de préférence de 1,80 à 2,10 et en particulier de 1,85 à 2,00 et avec des éléments diffusants de préférence d'indice de réfraction nₑ distinct de n₄, de préférence distinct d'au moins 0,1, de préférence d'au moins 0,2 et en particulier d'au moins 0,25,
- une couche partiellement structurée en épaisseur, électriquement isolante, de composition donnée d'indice de réfraction n₃ de 1,70 à 2,3, de préférence de 1,80 à 2,10 et en particulier de 1,85 à 2,00, qui est (de préférence directement) sur la couche d'extraction de lumière, couche partiellement structurée notamment sous-jacente et en contact avec la grille, - le cas échéant l'écart en valeur absolue n₃- n₄ étant de préférence à inférieur à 0,1 -, couche partiellement structurée formée :
   - d'une région structurée (la plus éloignée de la couche d'extraction de lumière, autrement dite région haute) avec des cavités, région, de préférence électriquement isolante, incluant les domaines non électroconducteurs, les cavités contenant la grille métallique,
   - d'une autre région (non structurée), sous la grille métallique (et directement sous la région structurée), et (de préférence directement) sur la couche d'extraction de lumière, et de préférence électriquement isolante.

La grille sous affleure la surface, dite surface haute (la plus éloignée du substrat), des domaines non électroconducteurs et l'écart H entre la surface haute et la surface de la grille métallique (dite surface supérieure, la plus éloignée du substrat) est, en valeur absolue, supérieur à 100nm, mieux supérieur à 150nm, et de préférence inférieur ou égal 500nm. H est mesuré entre la surface haute et le milieu de la surface de brin. Et les brins présentent suivant leur longueur une zone centrale entre des zones latérales (planes) qui affleurent la surface haute.

En intercalant entre la grille et le substrat verrier une telle couche d'extraction de lumière avec une fonction de diffusion de la lumière on augmente de manière considérable les performances optiques.

En plaçant la couche d'extraction de lumière sous la grille et non entre la grille, on peut ajuster indépendamment l'épaisseur de la grille (influant sur sa résistance carré notamment) et l'épaisseur de cette couche d'extraction de lumière (influant ses propriétés d'extraction de lumière). L'épaisseur totale E entre la première surface du substrat et la (face inférieure de la) grille métallique est de préférence d'au moins 1µm mieux entre 5 et 30µm.

En outre, les brins sont allongés - disjoints ou de préférence interconnectés (au moins dans la région émettrice de lumière) notamment en maille-.

Lors d'essais, la Demanderesse a constaté l'importance d'un écart suffisant entre la surface de la grille et la surface haute. En effet dans le cas de grilles suraffleurantes, ou sous affleurantes avec des plus faibles valeurs de H, la Demanderesse a observé l'apparition de protubérances de hauteur H1 de l'ordre de 20nm à 200nm et de largeur W1 à mi-hauteur de l'ordre de 20 à 500nm longeant les bords intérieurs des zones latérales (bords opposés aux bords extérieurs en contact avec la couche partiellement structurée, affleurant la surface haute) . Ces protubérances sont continues ou discontinues. Ces protubérances sont nuisibles car susceptibles d'augmenter les courants de fuite. L'écart H selon l'invention permet de réduire significativement ces protubérances et leur hauteur voire même de les supprimer.

Le fait que chaque zone latérale soit affleurante à la surface haute vient du procédé de fabrication : dépôt par voie liquide du métal, comme le dépôt autocatalytique (« electroless » en anglais) reposant sur la réduction d'un sel métallique en solution, dépôt réalisé au travers des ouvertures d'une couche de masquage sur la couche partiellement structurée par gravure humide. Ce phénomène d'affleurement est indépendant de l'épaisseur de métal.

En particulier, dans l'exemple d'un dépôt par argenture (« silvering » en anglais), l'argent est déposé dans les cavités au travers des ouvertures d'une couche de masquage. Les cavités sont plus larges que les ouvertures de la couche de masquage du fait de la gravure latérale qui intervient lors de la formation de la couche partiellement structurée par gravure humide. L'argent se dépose sur les flancs et sur la surface dite interne de la couche de masquage qui est située au-dessus de chaque cavité, surface interne dans le plan de la surface haute et donc dépassant des flancs de chaque cavité.

Avec un écart H faible, les protubérances sont générées lors du retrait de la couche de masquage dans cette zone de contact avec l'argent. On suppose que lorsque l'écart H est faible (brins quasi affleurants) la rupture entre l'argent déposé dans la cavité et celui sur les flancs de la couche de masquage est plus délicate à réaliser en raison d'une zone de contact argent/couche de masquage plus grande.

La majorité des brins et même chaque brin selon l'invention peut être dénué de ces protubérances. Selon l'invention, la surface de brin, de préférence argent, est considérée comme étant dénuée de protubérances lorsque ces protubérances longeant les bords intérieurs des zones latérales ont une hauteur inférieure à 10nm.

De manière préférée, la grille métallique est en argent et obtenue par argenture. On préfère même par simplicité que la grille métallique soit directement en contact avec la couche partiellement structurée (pas de couche entre la grille et le fond des cavités).

Lors d'un dépôt physique en phase vapeur (« PVD ») comme une pulvérisation cathodique magnétron, par effet d'ombrage au travers des ouvertures d'une couche de masquage tel qu'une (photo)résine, les zones latérales des brins sont en cuvette, formant une rupture de morphologie de profondeur équivalente à la hauteur des cavités e_{c} susceptible de générer des courts circuits lorsque l'OLED est fabriquée par la suite. Dans ce type de dépôt, le brin n'a pas de zone latérale affleurant la surface haute pour une grille sous affleurante.

En outre, l'argenture est simple, moins complexe (pas d'installations sous vide etc) que le dépôt physique en phase vapeur « PVD », et convient pour toute taille de grille. Par ailleurs, la conductivité électrique de l'argent déposé par argenture est suffisante (typiquement 30% à 40% inférieure à celle d'une grille d'argent faite par PVD).

Les zones latérales affleurant la surface haute sont planes, lisses du fait de leur contact avec la couche de masquage (photorésine) elle-même de surface interne plane, lisse. La surface interne reproduit quant à elle le caractère lisse, plan de la surface haute. La gravure humide ne génère pas de rugosités sur la surface interne et les flancs et fond de cavités sont également lisses. La discontinuité entre zone latérale et zone centrale est moins marquée que pour un dépôt par PVD, discontinuité d'amplitude H largement inférieure à e_{c}.

De préférence, le paramètre de rugosité Rq (de la surface) des zones latérales (planes) est d'au plus 5nm et même d'au plus 3nm et même d'au plus 2nm ou encore 1nm. Et de préférence le Rmax (hauteur maximale) dans chaque zone latérale (plane) est d'au plus 20nm et même d'au plus 10nm. Ces zones latérales lisses sont une condition nécessaire pour diminuer les courants de fuite.

Ces gammes de rugosités sont obtenues pour une grille déposée par argenture avec la couche de masquage en photorésine comme déjà décrit.

De préférence, chaque zone latérale est de largeur L1 supérieure à la hauteur e_{c} de la cavité et avec L1≤2e_{c} et même L1≤1,4e_{c}. La rugosité de surface de la zone centrale, sous affleurant la surface haute, peut être supérieure à la rugosité de surface des zones latérales (lisses) pour un dépôt par voie liquide comme le dépôt autocatalytique (par argenture etc). Le paramètre de rugosité Rq (ou rms) dans la zone centrale (la plus rugueuse) peut être d'au moins 10nm et même d'au moins 20nm et de préférence d'au plus 60nm. Et même le paramètre de rugosité Rmax (hauteur maximale) dans la zone centrale (la plus rugueuse) peut être d'au moins 100nm et même d'au moins 150nm et de préférence d'au plus 500nm.

La rugosité de la zone centrale augmente avec l'épaisseur de la grille métallique.

Rmax et Rq de la grille peuvent être définis selon la norme ISO4287 et mesurés par microscopie à force atomique.

Selon l'invention une zone latérale affleurant la surface haute peut être rigoureusement sur le même plan que la surface haute ou s'en écarter d'au plus 10nm et mieux d'au plus 5nm.

Avantageusement, la grille métallique selon l'invention peut présenter une résistance carré inférieure ou égale à 100hm/carré, de préférence inférieure ou égale à 50hm/carré, et même 10hm/carré.

Le ou les matériaux de la grille métallique sont choisis dans le groupe formé par l'argent, le cuivre, voire le nickel, notamment matériau pur ou peut être un alliage à base de ces métaux. La grille est de préférence à base d'argent.

La grille métallique peut être de préférence monocouche (argent) voire multicouche (de préférence avec au moins 80% même 90% en argent).

La grille métallique peut être multicouche, notamment multicouche argent, et comprendre (voire être constituée) -dans cet ordre-:
- une première couche métallique (directement sur le fond des cavités ou couche métallique la plus proche du fond des cavités), de préférence en un premier matériau métallique, qui est de préférence à base d'argent voire constitué d'argent, formant moins de 15% et même 10% de l'épaisseur totale e₂ de la grille et/ou d'au moins 3nm, 5nm voire d'au moins 10nm, et de préférence de moins de 100nm voire de 50nm,
- une deuxième couche métallique (sur la première couche, en s'éloignant du substrat), notamment avec une interface discernable avec la première couche, à base d'un deuxième matériau métallique qui est de préférence choisi parmi l'argent, aluminium ou cuivre, formant au moins 70%, 80% et même 90% de l'épaisseur totale e₂ de la grille deuxième couche qui est de préférence à base d'argent voire constitué d'argent notamment comme la première couche.

On peut notamment former une première couche métallique à base d'argent selon une première méthode de dépôt par exemple déposé par argenture de préférence d'épaisseur d'au moins 20nm et même d'au moins 30nm, ou par dépôt sous vide (pulvérisation) et une deuxième couche métallique à base d'argent d'épaisseur d'au moins 3nm voire 5nm, selon une deuxième méthode de dépôt de préférence qui est l'électrodéposition. L'avantage de l'électrodéposition est un taux d'utilisation d'argent plus grand que l'argenture et un procédé moins couteux de la pulvérisation.

La grille métallique peut être multicouche avec des couches en matériaux distincts, par exemple avec une dernière couche de protection contre la corrosion (eau et/ou air), par exemple métallique, en un matériau distinct de la couche métallique sous-jacente, notamment distinct de l'argent, d'épaisseur inférieure à 10nm mieux inférieure à 5nm ou même 3nm. Cette couche est utile en particulier pour une grille à base d'argent.

La grille métallique peut être en outre multicouche avec deux couches en matériaux distincts, être par exemple bicouche, et composée :
- d'une (seule) couche métallique en les matériaux précités, de préférence à base voire en argent, d'épaisseur d'au moins 100nm de préférence, par exemple déposé par argenture ou dépôt sous vide (pulvérisation),
- et d'une surcouche de protection contre la corrosion (eau et/ou air), par exemple métallique, en un matériau distinct de la couche métallique, notamment distinct de l'argent, d'épaisseur inférieure à 10nm, mieux inférieure à 5nm ou même 3nm

La grille métallique peut être une couche métallique comme l'argent et être revêtue d'une surcouche de protection, notamment temporaire, notamment polymétrique.

La grille métallique peut être déposée de préférence directement sur la couche partiellement structurée voire sur une sous-couche diélectrique, notamment d'accroché (à fonction d'accroché pour faciliter le dépôt de matériau de grille). La sous-couche est directement sur les cavités (le fond et de préférence tout ou partie des flancs des cavités) de la couche partiellement structurée et de préférence est absente de la surface haute, couche d'accroché de préférence minérale, notamment d'oxyde(s), par exemple un oxyde transparent conducteur. La sous-couche diélectrique est d'épaisseur e_{A} inférieure à 30nm même à 10nm. Cette couche d'accroché se dépose facilement par pulvérisation cathodique magnétron.

L'épaisseur e₂ de la grille métallique étant inférieure à la hauteur e_{c} des cavités entre les domaines non électroconducteurs de préférence e_{c} est supérieure à 200nm, même supérieure à 250nm ou à 500nm.

On choisit A inférieure ou égale à 50µm pour limiter la visibilité à l'oeil nu des brins et e₂ d'au moins 100nm pour atteindre l'objectif de Rcarré basse plus aisément.

Les brins sont interconnectés dans la zone active de l'OLED ou connectés (seulement) via leurs extrémités à des contacts électriques.

La présence d'éléments diffusants en grand nombre à la surface de la couche additionnelle diffusante seule ou la texturation de la première surface diffusante pourrait être source de court-circuits en répercutant une rugosité trop forte sur la grille qui serait déposée directement dessus.

On préfère donc que la grille ne soit pas en contact avec la surface de la couche d'extraction de lumière mais que la grille soit ancrée dans la couche partiellement structurée dont la surface haute est de préférence plane localement du moins à l'échelle pertinente pour les courts circuits soit dans une gamme de longueur inférieure à 50µm et par exemple supérieure à 10µm. La grille peut être sous forme de brins linéaires parallèles entre eux et raccordés (entre eux) à des contacts électriques à leurs extrémités et/ou encore sous forme de motifs fermés ou mailles (brins interconnectés entre eux définissant des motifs fermés), par exemple géométriques (rectangle, carré, polygone, nid d'abeille...) et de forme irrégulière et/ou de taille irrégulière. La grille peut avoir une zone à lignes (brins ou pistes en bandes) et une zone à motifs fermés (brins ou pistes en maille). On adapte la structuration de la couche partiellement structurée à cet effet.

L'épaisseur e2 n'est pas forcément constante dans une cavité. De préférence elle est définie au centre de la surface du brin. La largeur A n'est pas forcément constante dans une cavité donnée. De préférence elle est définie au niveau de la surface supérieure de la grille. On peut définir B au niveau de la surface supérieure de la grille comme la distance maximale entre les brins notamment correspondant à une distance maximale entre deux points d'une maille ou la distance maximale entre deux brins disjoints voisins type sillons (droits ou non).

A et B peuvent varier d'un brin à l'autre. La grille pouvant être irrégulière et/ou les bords des brins pouvant être inclinés, les dimensions A et B sont donc de préférence des dimensions moyennes sur les brins tout comme e₂. L'épaisseur e₂ (définie au centre de la surface du brin) peut être inférieure à 1500nm, mieux à 1000nm, notamment dans une gamme allant de 100nm à 1000nm, ou inférieure à 800nm et en particulier dans une gamme allant de 200nm à 800nm.

La largeur A est de préférence inférieure à 30µm. A est de préférence dans une gamme allant de 1 à 20µm, encore plus préférentiellement de 1,5µm à 20µm ou même de 3µm à 15µm. B peut être d'au moins 50µm et même d'au moins 200µm et B est inférieur à 5000µm, mieux inférieur à 2000µm même à 1000µm.

Une autre caractéristique de la grille métallique selon l'invention est un taux de couverture T qui est de préférence inférieur à 25% et encore mieux à 10%, et même à 6% ou à 2%.

En particulier on peut souhaiter un B entre 2000 et 5000µm lorsque e₂ est entre 800 et 1500nm et A est compris entre 10 et 50µm. Cela correspond à un taux de couverture compris entre 0,4 et 6,0%.

En particulier, on peut souhaiter un B entre 200 et 1000µm lorsque e₂ est inférieure à 500nm et A compris entre 3 et 20µm ou 3 à 10µm. Cela correspond à un taux de couverture compris entre 0,5 et 22% ou 0,5 à 11%.

Les cavités (formées en grille, définissant l'arrangement de la grille métallique), sont partiellement remplies par la grille métallique. Les cavités sont délimités par un fond et des flancs le plus souvent formant une cuvette.

Les cavités séparant les domaines non électroconducteurs peuvent être de hauteur e_{c} supérieure à 200nm, et même d'au moins 250nm ou 500nm et de préférence inférieure 1500nm ou 1200nm et de largeur A_{c} inférieure ou égale à 30µm. e_{c} est pris au centre de la cavité. A_{c} est pris de préférence au fond de la cavité.

Les cavités peuvent former des sillons (unidimensionnels), régulièrement espacés ou non notamment disjoints (au moins dans la zone émettrice de lumière) de toute forme par exemple droits ou sinueux.

Les cavités peuvent former un maillage c'est-à-dire un réseau d'ouvertures interconnectés (bidimensionnel), périodique ou apériodique, de maille régulière ou irrégulière, de toute forme : géométrique notamment (carré, rectangle, nid d'abeille). La maille peut être définie par une largeur maximale entre deux points d'une maille B_{c}.

On définit une distance horizontale L (entre l'extrémité de la surface haute et l'extrémité la plus proche du fond de cavité) telle que L est supérieure à e_{c} et L≤2e_{c} ou même L≤1,4e_{c}. L est souvent supérieure à e_{c} lorsqu'on utilise la gravure humide pour former la couche partiellement structurée.

L1 est généralement sensiblement égale à cette distance horizontale L. Plus précisément c'est la largeur L0 de la surface interne dépassante de la couche de masquage qui est sensiblement égale à la distance horizontale L. L1 vaut L0+e₂ environ. On préfère ainsi limiter l'étalement (latéral) des cavités pour réduire au mieux la largeur des brins. Pour une Rcarré donnée on privilégie une grande épaisseur à une large taille des brins pour gagner en transparence.

La couche partiellement texturée est, de préférence directement sur la couche d'extraction de lumière, en particulier de préférence apte à couvrir ou combler le profil de rugosité de la première surface diffusante du verre ou d'une couche additionnelle diffusante. La surface haute de la couche partiellement structurée ne reproduit donc pas (ni n'amplifie) la rugosité de la première surface diffusante du verre ou de la couche additionnelle diffusante.

Il est donc préférable que la couche partiellement structurée ait peu ou pas de particules diffusantes, et même n'ait pas une fonction diffusante (significative).

Pour préserver la surface haute et la rendre la plus lisse localement possible, (au moins) la région structurée notamment en matériau vitreux et de préférence en émail, est de préférence exempte de particules diffusantes sur toute son épaisseur.

On peut aussi préférer que la région structurée, de préférence électriquement isolante, préférentiellement en matériau vitreux et mieux encore en émail, ne contienne pas ou peu de pores en surface et même en épaisseur.

Et de préférence pour préserver la surface du fond des cavités, la région basse, notamment en matériau vitreux et de préférence en émail, est de préférence exempte de particules diffusantes sur toute son épaisseur. La région basse contient éventuellement (uniquement) des pores (bulle d'air ou de gaz), diffusants ou non, notamment concentration volumique inférieure à 0,5%, de préférence inférieure à 0,2% et en particulier inférieure à 0,1%.

Concernant la diffusion de la lumière, la région basse, notamment en matériau vitreux et de préférence en émail, peut contenir des pores mais en quantité si faible et/ou si petits (non diffusants) qu'ils ne rendent pas la couche partiellement structurée diffusante, notamment n'augmente pas la valeur de flou de l'ensemble substrat/ couche d'extraction de lumière/ couche partiellement structurée par rapport au flou du substrat/couche d'extraction de lumière seul.

La couche partiellement structurée, notamment en matériau vitreux et de préférence en émail, peut contenir des pores mais en quantité si faible et/ou si petits (non diffusants) qu'ils ne rendent pas cette couche (significativement) diffusante et de préférence ne perturbent pas la surface haute.

La surface haute de la couche partiellement structurée, notamment en matériau vitreux et de préférence en émail, peut présenter de préférence une rugosité Ra (paramètre bien connu Ra qui est l'écart moyen arithmétique du profil) inférieure à 5nm, mieux 3nm et même à 1nm. Ra peut être définie selon la norme ISO4287 et mesurée par microscopie à force atomique.

La surface de la couche destinée à former la couche partiellement structurée peut présenter des ondulations à grande échelle par exemple une amplitude de 1µm sur 100 à 200µm de période latérale W. Ces ondulations ne gênent pas la structuration car la largeur de la cavité A_{c} est beaucoup plus petite que W.

La couche partiellement structurée peut être d'épaisseur e₃ supérieure à 3µm de préférence inférieure à 30µm.

Pour avoir une surface haute la plus plane localement, en particulier si la couche d'extraction de lumière est une couche additionnelle diffusante en matrice haut indice et avec des particules diffusantes dispersées dans la matrice, on préfère avoir e₃ supérieure à 3µm et même 5µm ou 8µm et encore mieux 9µm, de préférence inférieure à 30µm et mieux à 25µm. La gamme préférée est de 9 à 20µm.

Pour avoir une surface haute la plus plane localement, en particulier si la couche d'extraction de lumière comporte une surface diffusante, par exemple la première surface du verre, on préfère e₃ supérieure à 5µm et même à 8µm et encore mieux 9µm, et de préférence e₃ est inférieure à 30µm et mieux inférieure ou égale à 25µm. La gamme préférée est de 10 à 20µm.

Dans un mode de réalisation avantageux, robuste et simple à mettre en oeuvre, la couche partiellement structurée électriquement isolante, est minérale, préférentiellement à base d'oxyde(s) ou essentiellement d'oxyde(s), et encore plus préférentiellement un matériau vitreux, en particulier un émail, à base de fritte de verre fondue.

La couche partiellement structurée peut par exemple être constituée du matériau vitreux (émail etc) de la couche additionnelle diffusante, ou d'un autre matériau vitreux.

Lorsque les matériaux vitreux sont identiques, l'interface entre la couche additionnelle diffusante et la couche partiellement structurée n'est pas forcément « marqué »/observable même si déposées l'une après l'autre.

La couche partiellement structurée en émail peut contenir des pores mais en quantité si faible et/ou si petits qu'ils ne rendent pas la couche (significativement) diffusante et/ou de préférence ne perturbent pas la surface haute.

La couche d'extraction de lumière additionnelle peut comporter une surface diffusante (avec contraste d'indice avec la couche partiellement structurée) et/ou des éléments diffusants (particules; pores etc) dispersés dans un milieu (minéral, mieux vitreux, notamment émail etc) de préférence haut indice. La surface diffusante peut être formée par des particules en saillie d'un milieu (minéral, mieux vitreux, notamment émail etc) avec un contraste d'indice avec la couche partiellement structurée.

La couche additionnelle diffusante peut être une monocouche ou une multicouche, peut avoir un gradient d'éléments diffusants (de préférence une décroissance d'éléments diffusants notamment de particules et/ou de bulles en direction de la grille) notamment être une bicouche avec un gradient d'éléments diffusants et/ou des éléments diffusants distincts (nature et/ou concentration).

La couche additionnelle diffusante notamment en émail peut avoir une épaisseur e₄ comprise entre 1µm et 80µm, en particulier de 2 à 30µm et même de 3 à 20µm.

Les éléments diffusants, en particulier les particules diffusantes, peuvent être répartis de manière homogène dans le matériau vitreux. Ils peuvent alternativement être répartis de manière hétérogène, en ménageant par exemple des gradients. La couche additionnelle diffusante peut également être constituée de plusieurs couches élémentaires se différenciant l'une de l'autre par une nature, une taille ou une proportion différente d'éléments diffusants.

De préférence, les éléments diffusants sont choisis parmi les particules et les pores. La couche additionnelle diffusante peut contenir à la fois des particules et des pores.

Les particules sont de préférence choisies parmi les particules d'alumine, de zircone, de silice, de dioxyde de titane, de carbonate de calcium, de sulfate de baryum. La couche diffusante peut comprendre un seul type de particules, ou plusieurs types de particules différentes.

Les éléments diffusants présentent de préférence une dimension caractéristique permettant une diffusion de la lumière visible. Les éléments diffusants (particules notamment) ont de préférence un diamètre moyen, déterminé par DLS (« dynamic light scattering » en anglais), compris entre 0,05 et 5µm, en particulier entre 0,1 et 3µm.

La concentration massique de particules diffusantes de la couche additionnelle diffusante est de préférence comprise dans un domaine allant de 0,2 à 10%, notamment de 0,5 à 8%, et même de 0,8 à 5%.

Bien que la nature chimique des particules diffusantes ne soit pas particulièrement limitée, elles sont de préférence choisies parmi les particules de TiO₂ et de SiO₂.

Une couche diffusante sous forme d'une matière polymérique comportant des particules diffusantes par exemple décrite dans EP1406474 est possible.

La couche additionnelle diffusante éventuelle est de préférence minérale, de préférence à base d'oxyde(s), mieux essentiellement d'oxyde(s), et la couche partiellement structurée est de préférence minérale, de préférence à base d'oxyde(s), notamment identique à la couche additionnelle diffusante et de préférence le verre est minéral.

Dans une réalisation préférée, la couche additionnelle diffusante est une couche minérale, directement sur le substrat, de matière minérale haut indice à base d'oxyde(s), préférentiellement une matière vitreuse, en particulier un émail, et les éléments diffusants de préférence sont des porosités et/ou de type minéral (cristaux précipités, particules creuses ou pleines, par exemple d'oxydes ou céramiques non oxydes...).

Avantageusement, on préfère des solutions « tout minéral » notamment :
- le substrat est de préférence en verre minéral, la couche d'extraction de lumière comporte (voire est constituée de) une couche additionnelle diffusante avec des éléments diffusants et une matière qui comporte (notamment est constituée de) un matériau vitreux, de préférence un émail, la composition de la couche partiellement structurée comporte (notamment est constituée de) un matériau vitreux, de préférence un émail, composition de préférence identique à la matière de la couche additionnelle diffusante,
- et/ou la première surface (rendue) diffusante du substrat, de préférence en verre minéral, fait partie de, voire constitue, la couche d'extraction de lumière et la composition de la couche partiellement structurée comporte (notamment est constituée de) un matériau vitreux, de préférence un émail.

Une couche en émail selon l'invention (couche partiellement structurée et/ou couche additionnelle diffusante) est obtenue de préférence par un procédé dans lequel on mélange une fritte de verre et un medium typiquement organique pour former une pâte, contenant éventuellement des particules diffusantes, que l'on dépose de préférence par sérigraphie sur la première surface, en verre minéral, avant de la cuire.

Pour une couche additionnelle diffusante en émail, les pores sont de préférence formés lors de la cuisson par élimination de composés organiques, par exemple du médium. Ils sont de préférence fermés et non connectés.

Des couches diffusantes haut indice en émail et des couches en émail haut indice sur des couches diffusantes sont connues dans la technique et sont décrites par exemple dans EP2178343 et WO2011/089343. Des compositions haut indice sont également décrites dans les brevets WO2010084922 et WO2010084925.

La couche partiellement structurée en émail d'indice n₃, et de préférence dénuée de particules diffusantes, peut comprendre un fort taux d'oxyde de bismuth par exemple au moins 40% en poids et mieux d'au moins 55% et de préférence d'au plus 85%. On choisit de préférence une émail de température de transition vitreuse Tg inférieure à 520°C et mieux inférieure ou égale à 500°C ou même inférieure ou égale à 490°C, et notamment d'au moins 450°C. La Tg est mesurée par calorimétrie différentielle à balayage (DLC pour Differential Scanning Calorimetry en anglais). La température de cuisson pour former l'émail est supérieure à la Tg mais ne doit pas ramollir le substrat en verre. De préférence la température de cuisson est inférieure à 600°C même inférieure à 570°C notamment lorsque la Tg est inférieure ou égale à 500°C.

La couche additionnelle diffusante, de préférence contenant des particules diffusantes et éventuellement des pores, peut (aussi) être en émail (diffusant). On choisit de préférence un émail de température de transition vitreuse Tg inférieure à 600°C et mieux inférieure ou égale à 550°C ou même inférieure ou égale à 500°C. L'émail diffusant peut être haut indice, d'au moins 1,7, comprendre un fort de taux d'oxyde de bismuth par exemple au moins 40% en poids et mieux d'a moins 55% en poids et de préférence d'au plus 85%. La Tg est mesurée par calorimétrie différentielle à balayage (DLC pour Differential Scanning Calorimetry en anglais). La température de cuisson pour former l'émail est supérieure à la Tg mais ne doit pas ramollir le substrat en verre. De préférence la température de cuisson est inférieure à 600°C même inférieure à 570°C notamment lorsque la Tg est inférieure ou égale à 500°C.

La première surface peut être suffisamment rugueuse pour être diffusante. Des interfaces rugueuses destinées à extraire la lumière émise par les couches organiques des OLED sont connues et décrites par exemple dans les demandes WO2010/112786, WO02/37568 et WO2011/089343. La rugosité de la première surface du substrat peut être obtenue par tout moyen approprié connu, par exemple par gravure acide (acide fluorhydrique), sablage ou abrasion. La texturation de la première surface du substrat (rendue) diffusante de préférence est non périodique, notamment aléatoire, pour l'application lumière blanche.

La rugosité du substrat est caractérisée par le paramètre de rugosité bien connu Ra qui est l'écart moyen arithmétique du profil, traduisant l'amplitude moyenne. Ra peut être définie selon la norme ISO4287 et mesurée par microscopie à force atomique. Typiquement Ra est micronique, de préférence inférieure à 5µm voire à 3µm.

Par l'emploi de l'adjectif « diffusant » pour qualifier la première face diffusante et/ou la couche additionnelle diffusante, on entend de préférence que le flou (de l'ensemble substrat verrier et couche d'extraction de lumière et éventuellement de la couche partiellement structurée) est d'au moins 60%, mieux 70, et même 80% ou 90%. Le flou, parfois appelé « voile » est mesuré par un haze-meter, comme celui de la société BYK, en prenant le protocole défini dans la norme ASTM D1003.

Lorsque le substrat n'est pas à fonctionnalité diffusante (par une première surface diffusante, rugueuse), on préfère qu'il ait un flou inférieur à 5%, mieux à 2% et même inférieure à 1%.

Par ailleurs, on préfère :
- que l'ensemble substrat et couche d'extraction de lumière ait une transmission lumineuse T_{L} d'au moins 40%, voire 50% et de préférence une absorption d'au plus 5% voire 3%,
- et même que l'ensemble substrat - couche d'extraction de lumière (de préférence en matériau vitreux, en émail) - couche partiellement structurée (de préférence en matériau vitreux, mieux en émail et directement sur la couche d'extraction de lumière) ait une T_{L} d'au moins 40% voire 50%, et de préférence une absorption d'au plus 5% voire 3%.

La couche partiellement structurée selon l'invention peut être sur une grande surface par exemple une surface supérieure ou égale à 0,005 m² voire même supérieure ou égale à 0,5 m² ou à 1 m². La grille selon l'invention peut être sur une grande surface par exemple une surface supérieure ou égale à 0,02 m² voire même supérieure ou égale à 0,5 m² ou à 1 m².

On peut rajouter une couche typiquement, barrière aux alcalins:
- entre la première surface du substrat en verre minéral (surface rendue diffusante ou surface plane, éventuellement polie) et la couche additionnelle diffusante.
- et/ou entre la première surface du substrat en verre minéral (surface rendue diffusante ou surface plane, polie classique) et la couche partiellement structurée de préférence électriquement isolante.

Cette couche par exemple déposée par dépôt physique en phase vapeur PVD est généralement de surface conforme à la surface du substrat, à la surface sous jacente et donc ne joue pas (ou peu) le rôle de planarisation.

La couche barrière aux alcalins peut être à base de nitrure de silicium, d'oxycarbure de silicium, d'oxynitrure de silicium, d'oxycarbonitrure de silicium, ou de silice, alumine, d'oxyde de titane, d'oxyde d'étain, de nitrure d'aluminium, de nitrure de titane, de Ti(Zr)O par exemple d'épaisseur inférieure ou égale à 100nm ou même à 30nm et de préférence supérieure ou égale à 3nm même à 5nm. Il peut s'agir d'une multicouche.

On peut rajouter une couche barrière à l'humidité sur le substrat choisi plastique (de surface rendue diffusante ou surface plane). La couche barrière peut être à base de nitrure de silicium, d'oxycarbure de silicium, d'oxynitrure de silicium, d'oxycarbonitrure de silicium, ou de silice, alumine, d'oxyde de titane, d'oxyde d'étain, de nitrure d'aluminium, de nitrure de titane, par exemple d'épaisseur inférieure ou égale à 10nm et de préférence supérieure ou égale à 3nm même à 5nm. Il peut s'agir d'une multicouche.

Dans la présente invention, tous les indices de réfraction sont définis à 550nm.

Le support électroconducteur selon l'invention peut être utilisé pour un dispositif électroluminescent organique à émission par l'arrière (« bottom emission » en anglais) ou pour un dispositif électroluminescent organique à émission par l'arrière et l'avant.

Dans la présente invention, toute couche diélectrique peut être dopée. Le dopage s'entend d'une manière habituelle comme exposant une présence de l'élément dans une quantité inférieure à 10% en masse d'élément métallique dans la couche. Un oxyde ou nitrure métallique peut être dopé notamment entre 0,5 et 5%. Toute couche d'oxyde métallique selon l'invention peut être un oxyde simple ou un oxyde mixte dopé ou non.

Au sens de la présente invention lorsqu'il est précisé qu'un dépôt de couche ou de revêtement (comportant une ou plusieurs couches) est effectué directement sous ou directement sur un autre dépôt, c'est qu'il ne peut y avoir interposition d'aucune couche entre ces deux dépôts.

Le support électroconducteur peut comporter un revêtement électroconducteur qui couvre, de préférence directement, les domaines non électroconducteurs et la grille métallique, notamment revêtement électroconducteur d'épaisseur e₅ inférieure ou égale à 500nm, de résistivité ρ₅ inférieure à 20Ω.cm, même à 10Ω.cm ou à 1Ω.cm et même à 10⁻¹Ω.cm et supérieure à la résistivité de la grille métallique, et est d'indice de réfraction n₅ donné d'au moins 1,55 mieux 1,6 et encore mieux 1,7.

On préfère ajuster la résistivité en fonction de la distance entre les brins. Elle est d'autant plus faible que B est grand.

Par exemple, pour B=1000µm, et e₅ =100nm, on préfère une résistivité de moins de 0,1 Ω.cm. Pour B de 200um et e₅ =100nm, on préfère une résistivité de moins de 1Ω.cm.

Le revêtement électroconducteur selon l'invention contribue à une meilleure répartition du courant.

La surface du revêtement électroconducteur peut être destinée de préférence à être en contact avec les couches organiques de l'OLED : notamment la couche d'injection de trous (« HIL » en anglais) ou la couche de transport de trous (« HTL » en anglais) ou faire partie de l'HIL ou de l'HTL ou jouer le rôle d'HTL ou HIL.

La surface (externe) du revêtement électroconducteur peut en outre présenter des ondulations à très grande échelle, typiquement supérieur à 0,1mm. Par ailleurs, le substrat peut être courbe.

Le revêtement électroconducteur est de préférence monocouche plutôt que multicouche.

La surface du revêtement peut reproduire la rugosité de surface de la grille, notamment obtenu par dépôt en phase vapeur. Le revêtement peut être sous-affleurant à la surface haute au-dessus de la zone centrale.

Le revêtement peut présenter une couche d'adaptation du travail de sortie qui peut avoir par exemple un travail de sortie Ws à partir de 4,5eV et de préférence supérieur ou égal à 5eV.

Le revêtement électroconducteur peut ainsi comprendre (ou de préférence est constitué de) une couche minérale d'indice de réfraction nₐ compris entre 1,7 et 2,3, de préférence qui est la dernière couche du revêtement (la plus éloignée du substrat), notamment d'adaptation du travail de sortie, de préférence d'épaisseur inférieure à 150nm, à base d'oxyde transparent électroconducteur, oxyde simple ou mixte :
- notamment à base de l'un au moins des oxydes métalliques suivants, éventuellement dopé : oxyde d'étain, oxyde d'indium, oxyde de zinc, oxyde de molybdène MoO₃, oxyde de de tungstène WO₃, oxyde de vanadium V₂O₅,
- d'ITO (de préférence), une couche (notamment amorphe), par exemple à base d'oxyde de zinc et d'étain SnZnO, ou à base d'oxyde d'indium et de zinc (dénommée IZO), ou à base d'oxyde d'indium, de zinc et d'étain (dénommée ITZO).

De préférence, une couche à base d'oxyde de zinc est dopée par aluminium et /ou gallium (AZO ou GZO).

Une couche en un oxyde de ZnO est dopée de préférence Al (AZO) et/ou Ga (GZO) avec la somme des pourcentages en poids de Zn+AI ou Zn+Ga ou Zn+Ga+Al ou de Zn+autre dopant de préférence choisi parmi B, Sc, ou Sb ou encore parmi Y, F, V, Si, Ge, Ti, Zr, Hf et même par In qui est d'au moins 90% en poids total de métal mieux d'au moins 95% et même d'au moins 97.

On peut préférer pour une couche d'AZO selon l'invention que le pourcentage en poids d'aluminium sur la somme des pourcentages en poids d'aluminium et de zinc, autrement dit Al/(Al+Zn), soit inférieur à 10%, de préférence inférieur ou égal à 5%.

Pour ce faire on peut utiliser de préférence une cible céramique d'oxyde d'aluminium et d'oxyde de zinc telle que le pourcentage en poids d'oxyde d'aluminium sur la somme des pourcentages en poids d'oxyde de zinc et d'oxyde d'aluminium, typiquement Al₂O₃/(Al₂O₃+ZnO), soit inférieur à 14% de préférence inférieur ou égal à 7%.

On peut préférer pour une couche de GZO selon l'invention que le pourcentage en poids de gallium sur la somme des pourcentages en poids de zinc et de gallium, autrement dit Ga/(Ga+Zn) est inférieur à 10% et de préférence inférieur ou égal à 5%.

Pour ce faire on peut utiliser de préférence une cible céramique d'oxyde de zinc et de gallium telle que le pourcentage en poids d'oxyde de gallium sur la somme des pourcentages en poids d'oxyde de zinc et d'oxyde de gallium, typiquement Ga₂O₃/(Ga₂O₃+ZnO), est inférieur à 11%, de préférence inférieur ou égal à 5%.

Dans une couche choisie à base d'oxyde d'étain et de zinc (SnZnO), le pourcentage en poids total de métal de Sn va de préférence de 20 à 90% (et de préférence de 80 à 10% pour Zn) et en particulier de 30 à 80% (et de préférence de 70 à 20 pour Zn), notamment le rapport en poids Sn/(Sn+Zn) va de préférence de 20 à 90% et en particulier de 30 à 80%.

La couche minérale, de préférence ITO ou à base d'oxyde de zinc, présente de préférence une épaisseur inférieure ou égale à 60nm, 50nm voire 40nm ou même 30nm et même à 10nm et est de résistivité inférieure à 10⁻¹Ω.cm. De préférence on choisit une couche déposée par dépôt physique en phase vapeur en particulier par pulvérisation magnétron, choisi parmi ITO et ZnO (AZO, GZO, AGZO), voire MoO₃, WO₃, V₂O₅.

On entend de préférence par oxyde d'indium-étain (ou encore oxyde d'indium dopé à l'étain ou ITO pour l'appellation anglaise : Indium tin oxide) un oxyde mixte ou un mélange obtenu à partir des oxydes d'indium (III) (In₂O₃) et d'étain (IV) (SnO₂), de préférence dans les proportions massiques comprises entre 70 et 95% pour le premier oxyde et 5 à 20% pour le second oxyde. Une proportion massique typique est d'environ 90% massique d'In₂O₃ pour environ 10% massique de SnO₂.

Le revêtement électroconducteur peut être constitué de la couche minérale d'indice de réfraction nₐ compris entre 1,7 et 2,3, alors égal à n₅.

Le revêtement électroconducteur peut comprendre ou être constitué, au moins en dernière couche (du revêtement) la plus éloignée du substrat, d'une couche organique en polymère(s) (électro)conducteur(s), d'épaisseur e'5 submicronique, d'indice de réfraction n_{b} d'au moins 1,55, mieux 1,6 cette couche polymérique pouvant jouer le rôle de couche de transport de trous dite HTL (Hole Transport Layer) ou d'injection de trou dite HIL (Hole Injection Layer) d'un système organique électroluminescent.

Le revêtement électroconducteur peut être constitué de la couche organique d'indice de réfraction n_{b} compris entre 1,7 et 2,3, alors égal à n₅.

Par exemple, il s'agit d'une couche d'un ou des polymères (électro)conducteurs de la famille des polythiophènes, comme le PEDOT, c'est-à-dire le 3,4-polyéthylènedioxythiopène ou PEDOT/PSS, c'est-à-dire le 3,4-polyéthylènedioxythiopène mélangé avec polystyrènesulfonate.

Comme PEDOT ou PEDOT:PSS commerciaux on peut citer de la société Heraeus :
- le Clevios™ F ET de p de moins de 10⁻² Ohm.cm,
- ou le Clevios™ HIL 1.1. de ρ de l'ordre de 10 Ohm.cm.

Le polymère (électro)conducteur fait partie de l'électrode et sert aussi éventuellement de couche d'injection de trous (HIL).

Le revêtement électroconducteur peut être multicouche et comprend, (de préférence directement) sous la couche minérale précitée (notamment dernière couche) ou la couche organique précitée (notamment dernière couche), une première couche directement sur la grille métallique (grille monocouche ou multicouche), en oxyde transparent électroconducteur, d'épaisseur e'5 inférieure à 200nm, d'indice n'5 compris entre 1,7 et 2,3, l'écart en valeur absolue n'5- n₃ étant de préférence inférieur à 0,1 notamment choisie parmi :
- de préférence une couche à base d'oxyde de zinc dopé notamment aluminium et /ou gallium (AZO ou GZO), ou éventuellement ou ITZO
- et/ou une couche (notamment amorphe), par exemple à base d'oxyde de zinc et d'étain SnZnO de préférence d'épaisseur inférieure à 100nm, ou à base d'oxyde d'indium et de zinc (dénommé IZO), ou à base d'oxyde d'indium, de zinc et d'étain (dénommé ITZO)

La couche d'AZO ou de GZO peut par exemple permettre de réduire l'épaisseur de la couche minérale notamment de la couche d'ITO à moins de 50 nm.

Le support électroconducteur peut aussi comporter une couche de protection temporaire (amovible) par exemple minérale, d'oxyde ou de nitrure par exemple, ou polymérique, ceci pour son transport dans le lieu de dépôt du revêtement électroconducteur, distinct du lieu de dépôt de la grille,

Le substrat peut être plan ou courbe, et en outre rigide, flexible ou semi-flexible.

Ses faces principales peuvent être rectangulaires, carrées ou même de toute autre forme (ronde, ovale, polygonale...). Ce substrat peut être de grande taille par exemple de surface supérieure à 0,02m² voire même 0,5m² ou 1m² et avec une électrode inférieure occupant sensiblement la surface (aux zones de structuration près).

Le substrat peut être substantiellement transparent, minéral ou en matière plastique comme du polycarbonate PC ou du polymétacrylate de méthyle PMMA ou encore le PET, du polyvinyle butyral PVB, polyuréthane PU, le polytétrafluoréthylène PTFE etc ...

Le substrat est de préférence en verre minéral, notamment en verre silicosodocalcique obtenu par le procédé de flottage (dit procédé « float »), consistant à déverser le verre fondu sur un bain d'étain en fusion. Le substrat est de préférence incolore, et présente (seul) un facteur de transmission lumineuse d'au moins 80%, voire 90% au sens de la norme EN 410 :1998.

Le substrat peut être avantageusement un verre présentant un coefficient d'absorption inférieur à 2,5m⁻¹, de préférence inférieur à 0,7m⁻¹ à la longueur d'onde du ou des rayonnements OLEDs. On choisit par exemple des verres silicosodocalciques avec moins de 0,05% de Fe III ou de Fe₂O₃, notamment le verre Diamant de Saint-Gobain Glass, le verre Optiwhite de Pilkington, le verre B270 de Schott. On peut choisir toutes les compositions de verre extraclair décrites dans le document WO04/025334.

L'épaisseur du substrat verrier peut être d'au moins 0,1mm, de préférence dans un domaine allant de 0,1 à 6mm, notamment de 0,3 à 3mm.

Le support tel que défini précédemment peut en outre comporter un système électroluminescent organique déposé (de préférence directement) sur le revêtement électroconducteur incluant éventuellement couche de transport de trous HTL ou d'injection de trou HIL.

L'invention a trait également à un dispositif électroluminescent organique incorporant le support tel que défini précédemment, l'électrode avec la grille métallique formant l'électrode dite inférieure, la plus proche du substrat, généralement l'anode, notamment couverte par une couche électroluminescente en matériau(x) électroluminescent(s) organique(s), couche électroluminescente couverte par l'électrode supérieure, généralement la cathode.

Pour l'électrode supérieure, on peut utiliser une couche métallique (réfléchissante, semi réfléchissante) par exemple en Ag, Al, Pd, Cu, Pd, Pt, In, Mo, Au.

Le dispositif OLED peut produire de la lumière monochromatique, notamment bleu et/ou verte et/ou rouge, ou être adaptée pour produire une lumière blanche.

Pour produire de la lumière blanche plusieurs méthodes sont possibles : mélange de composés (émission rouge vert, bleu) dans une seule couche, empilement sur la face des électrodes de trois structures organiques (émission rouge vert, bleu) ou de deux structures organiques (jaune et bleu), série de trois structures organiques adjacentes organiques (émission rouge vert, bleu), sur la face des électrodes une structure organique dans une couleur et sur l'autre face des couches luminophores adaptés.

Le dispositif OLED peut comprendre une pluralité de systèmes électroluminescents organiques adjacents, chacun émetteur de lumière blanche ou, par série de trois, de lumière rouge, verte et bleu, les systèmes étant par exemple connectés en série.

Chaque rangée peut par exemple émettre suivant une couleur donnée.

Les OLED sont généralement dissociés en deux grandes familles suivant le matériau organique utilisé.

Si les couches électroluminescentes sont des petites molécules on parle de SM-OLED (« Small Mollecule Organic Light Emitting Diodes » en anglais). Le matériau électroluminescent organique de la couche mince est constitué à partir de molécules évaporées comme par exemple le complexe d'AlQ₃ (tris(8-hydroxyquinoline) aluminium), le DPVBi (4,4'-(diphényl vinylène biphényl)), le DMQA (diméthyl quinacridone) ou le DCM (4-(dicyanométhylène)-2-méthyl-6-(4-diméthylaminostyryl)-4H-pyran).La couche émissive peut être aussi par exemple par une couche de 4,4',4"-tri(N-carbazolyl) triphenylamine (TCTA) dopé au fac tris(2-phenylpyridine) iridium [Ir(ppy)₃].

D'une manière générale la structure d'une SM-OLED consiste en un empilement de couche d'injection de trous ou « HIL » pour « Hole Injection Layer » en anglais, couche de transport de trous ou « HTL " pour « Hole Transporting Layer » en anglais, couche émissive, couche de transport d'électron ou « ETL » pour « Electron Transporting Layer » en anglais.

Des exemples d'empilements électroluminescents organiques sont par exemple décrits dans le document US 6 645 645.

Si les couches électroluminescentes organiques sont des polymères on parle de PLED (Polymer Light Emitting Diodes en anglais).

De préférence le revêtement électroconducteur est résistant aux étapes de fabrication de l'OLED suivantes :
- tenue à 200°C pendant 1 h,
- tenue à un pH de 13 (solution de nettoyage),
- tenue à un pH compris entre 1,5 et 2 (en particulier si dépôt pour le revêtement électroconducteur de polymère, avant dépôt du système OLED),
- résistance à l'arrachement (test au scotch).

Un moyen d'extraction de la lumière peut également être situé sur la face extérieure du substrat, c'est-à-dire la face qui sera opposée à la première face principale porteuse de l'électrode en grille. Il peut s'agir d'un réseau de microlentilles ou de micropyramides tel que décrit dans l'article dans Japanese Journal of Applied Physics, Vol. 46, n° 7A, pages 4125-4137 (2007) ou bien d'un satinage, par exemple un satinage par dépoli à l'acide fluorhydrique.

L'invention concerne enfin un procédé de fabrication d'un support électroconducteur tel que défini précédemment qui comporte les étapes suivantes dans cet ordre:
- la fourniture du substrat comportant :
   - la couche d'extraction de lumière de préférence formée par la première surface diffusante du substrat et/ou formée par une couche additionnelle diffusante (de préférence directement) sur la première surface du substrat,
   - sur la couche d'extraction de lumière, une couche dite haut indice, en la composition avec ledit indice de réfraction n₃, qui comporte ledit matériau vitreux, de préférence exempte de particules diffusantes et qui contient éventuellement des éléments de type pores à une concentration volumique inférieure à 0,5%, de préférence inférieur à 0,2% et en particulier inférieur à 0,1%, et de préférence couche haut indice planarisant la couche d'extraction de lumière,
- la formation d'ouvertures borgnes dites cavités dans la couche haut indice, formant ainsi la couche partiellement structurée, comportant :
   - la réalisation sur la couche haut indice d'une couche de masquage discontinue (couche de résine par exemple, photorésine en particulier, positive ou négative) avec un arrangement d'ouvertures traversantes donné (lignes et/ou mailles),
   - la gravure humide de la couche haut indice au travers des ouvertures traversantes de la couche de masquage, notamment ouvertures traversantes évasées (s'élargissant en direction opposée du substrat), les flancs de la couche de masquage dépassant des flancs des cavités et définissant ainsi des portions de surfaces dites surfaces internes de la couche de masquage en regard des cavités, - la largeur des ouvertures W0 étant inférieure à la largeur Wc des cavités au niveau de la surface haute -,
- la formation de la grille métallique (avec l'écart H entre la surface, dite haute, des domaines non électroconducteurs et la surface de la grille métallique) comprenant :
   - un dépôt par voie liquide, de préférence autocatalytique, d'un premier matériau métallique de la grille remplissant partiellement les cavités, de préférence l'unique dépôt pour la grille métallique, directement sur le fond des cavités -voire sur une sous-couche diélectrique (non métallique) tapissant tout en partie de la cavité (sous couche d'accroché etc)-, le premier matériau se déposant dans le fond des cavités, sur les flancs des cavités et entièrement sur les surfaces internes de la couche de masquage, formant ainsi les zones latérales de brin affleurant la surface haute et moins rugueuses que les zone centrales de brins (qui sont en regard des ouvertures),
   - le retrait de la couche de masquage (de préférence par voie liquide et même sous ultrasons), de préférence le retrait de la couche de masquage ne créant pas de protubérances de hauteur d'au moins 10nm sur la surface de grille.

La gravure est réalisée par un procédé de gravure humide. La profondeur des cavités est réglée par concentration de la solution, type de solution, durée de gravure, température de la solution. La couche de masquage, de préférence (photo)résine, est alors résistante à la solution de gravure.

Les cavités sont à flancs évasés en direction opposée du substrat (s'élargissant en s'éloignant du substrat). La section peut être en cuvette, même (de type) semi sphérique.

On peut en particulier utiliser une solution acide, avec une couche partiellement structurée en matériau vitreux (émail de préférence) et de préférence la couche de masquage est une (photo)résine notamment photorésine positive.

La gravure avec une solution humide notamment acide est verticale et latérale au sens où la solution de gravure (notamment acide) attaque (creuse) dans toutes les directions. Le profil de gravure peut être en cuvette, de type semi sphérique.

On dépose l'éventuelle couche d'accroche ensuite avant le premier matériau métallique.

De manière avantageuse, le dépôt par voie liquide (de préférence l'unique dépôt pour la grille métallique) peut être une argenture et de préférence la grille est une monocouche et même le premier matériau (qui est à base d'argent) est déposé directement dans le fond des cavités.

Alternativement, la formation de la grille métallique comprend un autre dépôt d'un deuxième matériau métallique de la grille sur le premier matériau métallique ou sous le premier matériau métallique.

Si l'autre dépôt est réalisé après le dépôt par voie liquide (comme l'argenture) ce peut être l'électrodéposition d'argent. Si l'autre dépôt est réalisé avant le dépôt par voie liquide (comme l'argenture), ce peut être la pulvérisation cathodique d'argent. Lorsque la grille est obtenue par deux procédés de dépôt distincts d'un même matériau comme de préférence l'argent (pulvérisation cathodique et argenture, argenture et électrodéposition) les couches d'argents peuvent se distinguer par leurs propriétés, notamment par une interface discernable.

La solution pour l'étape d'argenture peut contenir un sel d'argent, un réducteur des ions d'argent et même un agent chélatant. L'étape d'argenture peut être mise en oeuvre selon des modes opératoires classiques utilisés couramment dans le domaine de la fabrication des miroirs et décrits par exemple au chapitre 17 de l'ouvrage « Electroless Plating - Fundamentals and Applications », édité par Mallory, Glenn O.; Hajdu, Juan B. (1990) William Andrew Publishing/Noyes.

Dans un mode de réalisation préféré, l'étape d'argenture comprend (par plongeon dans un bain ou par pulvérisation d'une solution) la mise en contact du substrat ayant la couche d'extraction de lumière, la couche partiellement structurée et la couche de masquage à ouvertures traversantes (de préférence (photo)résine) avec un mélange de deux solutions aqueuses, l'une contenant le sel métallique, par exemple du nitrate d'argent, et l'autre contenant l'agent réducteur des ions métalliques (ions Ag⁺), par exemple du sodium, du potassium, des aldéhydes, des alcools, des sucres.

Les réducteurs les plus communément utilisés sont le sel de Rochelle (tartrate double de sodium et de potassium KNaC₄H₄O₆, 4H₂O), le glucose, le gluconate de sodium et le formaldéhyde.

De préférence avant cette mise en contact, l'étape d'argenture comprend une étape de sensibilisation (de la surface des cavités) comprenant de préférence un traitement par du sel d'étain et/ou une étape d'activation (de la surface des cavités) comprenant de préférence un traitement par un sel de palladium. Ces traitements ont essentiellement pour fonction de favoriser la métallisation (par l'argent) ultérieure et d'augmenter l'adhérence de la couche métallique d'argent formée (dans les cavités). Pour une description détaillée de ces étapes de sensibilisation et d'activation, on pourra se référer par exemple à la demande US 2001/033935.

Plus précisément, on peut procéder à l'argenture en plongeant le substrat ayant la couche d'extraction de lumière, la couche partiellement structurée et la couche de masquage à ouvertures traversantes, de préférence (photo)résine, dans des bacs, chacun avec une des trois solutions suivantes dans cet ordre:
- une première solution aqueuse de SnCl₂ (sensibilisation), de préférence avec agitation (pendant de préférence moins de 5minutes, par exemple 0,5 à 3min), puis rinçage à l'eau (distillée),
- une deuxième solution aqueuse de PdCl₂ (activation), de préférence avec agitation (pendant de préférence moins de 5min, par exemple 0,5 à 3min), puis rinçage à l'eau (distillée),
- une troisième qui est un mélange de la solution de sel d'argent de préférence de nitrate d'argent et de la solution du réducteur de l'argent, de préférence de gluconate de sodium, de préférence avec agitation (pendant de préférence moins de 15min et même de 5min, par exemple 0,5 à 3min), puis rinçage à l'eau (distillée).

Le substrat revêtu et ainsi argenté est ensuite retiré du dernier bain et rincé à l'eau (distillée).

Un autre mode de réalisation consiste à pulvériser les trois solutions précédentes dans le même ordre que précédemment plutôt qu'à plonger le substrat ayant la couche d'extraction de lumière, la couche partiellement structurée et la couche de masquage à ouvertures traversantes, de préférence (photo)résine.

Le retrait de la couche de masquage, de préférence une couche de résine par exemple, mieux une photorésine) est de préférence effectué par voie liquide, en particulier par ultrasons dans un solvant (acétone etc).

La couche haut indice comporte de préférence (mieux est constituée d') un émail, notamment obtenue à partir d'une première composition à base de fritte de verre. Et de préférence la couche additionnelle diffusante éventuelle comporte (mieux est constituée d') un émail avec des éléments diffusants obtenu à partir d'une autre composition à base de fritte de verre, notamment identique à la première composition.

La couche haut indice comprenant un matériau vitreux est de préférence un émail obtenu par un procédé dans lequel :
- on mélange une fritte de verre d'indice n₃ à un médium organique de manière à former une pâte, dite de planarisation, de préférence sans ajouter des particules diffusantes,
- on dépose ladite pâte, par exemple par sérigraphie,
- de préférence directement, sur la feuille de verre minérale (de surface diffusante) ou sur une couche barrière minérale sur la feuille de verre minérale (de surface diffusante) ou encore sur la couche additionnelle diffusante,
- on cuit l'ensemble.

La couche diffusante additionnelle comprenant un matériau vitreux est de préférence un émail obtenu par un procédé dans lequel :
- on mélange une fritte de verre à un médium organique et de préférence avec des particules diffusantes de manière à former une pâte dite de diffusion,
- on dépose ladite pâte, de préférence directement, sur la feuille de verre minérale (plane, polie ou texturée, diffusante) ou sur une couche barrière minérale sur la feuille de verre minérale,
- on cuit l'ensemble.

La couche additionnelle diffusante peut être formée par recuit de la pâte de diffusion avant le dépôt de la pâte de planarisation ou on peut recuire les deux pâtes ensemble (une étape en moins de recuit).

Dans une configuration on utilise la pâte de diffusion et la pâte de planarisation ayant la même composition notamment la même fritte de verre, et ne diffère que par la présence ou l'absence de particules diffusantes.

Le médium organique est typiquement choisi parmi des alcools, des glycols, des esters de terpinéol. La proportion massique de médium est de préférence comprise dans un domaine allant de 10 à 50%.

Le dépôt de la pâte (diffusion et/ou planarisation) peut être réalisé notamment par sérigraphie, par dépôt au rouleau, par trempage, par application au couteau, par pulvérisation, par tournette, par nappage vertical ou encore à l'aide d'une filière en forme de fente (slot die coating).

Dans le cas de la sérigraphie, on utilise de préférence un écran en maille textile ou métallique, des outils de nappage et un racle, la maîtrise de l'épaisseur étant assurée par le choix de la maille de l'écran et sa tension, par le choix de la distance entre la feuille de verre (ou de la couche additionnelle diffusante) et l'écran, par les pressions et vitesses de déplacement de la racle. Les dépôts sont typiquement séchés à une température de 100 à 150°C par rayonnement infrarouge ou ultraviolet selon la nature du médium.

Classiquement, la frite de verre (70 - 80% en poids) est mélangée avec 20 - 30% en poids d'un médium organique (éthyle cellulose et organique solvant).

La pâte peut subir un traitement thermique à une température dans une gamme allant de 120 et 200°C par exemple visant à figer la pâte. Ensuite la pâte peut subir un traitement thermique allant de 350 à 440°C pour supprimer le médium organique. La cuisson pour former l'émail est au-dessus de la Tg typiquement à une température inférieure à 600°C, de préférence inférieure à 570°C.

Un polissage de la surface haute et de la grille avant dépôt du revêtement électroconducteur ou après dépôt du revêtement électroconducteur est possible.

Le procédé peut comprendre en outre ultérieurement au retrait de la couche de masquage (résine, photorésine en particulier), - couvert par le ou les matériaux de grille-, une étape de dépôt, directement sur la grille et (directement) sur la couche partiellement structurée, du revêtement électroconducteur, revêtement monocouche ou multicouche :
- par dépôt physique en phase vapeur, notamment par pulvérisation cathodique, avec un éventuel premier dépôt de SnZnO ou AZO et un deuxième ou dernier ou de préférence unique dépôt d'ITO ou à base de ZnO (dopé), voire de MoO₃, WO₃, ou V₂O₅,
- et/ou par voie liquide par exemple d'un polymère (électro)conducteur, de préférence unique dépôt du revêtement électroconducteur choisi monocouche.

On peut préférer que l'ensemble des dépôts soient réalisés par voie liquide.

Le procédé peut comprendre une étape de chauffage (de l'électrode) avant le dépôt du revêtement électroconducteur à une température supérieure à 180°C, de préférence comprise entre 250°C et 450°C, en particulier entre 250°C et 350°C, pendant une durée comprise de préférence entre 5 minutes et 120 minutes, en particulier entre 15 et 90 minutes.

Et/ou le procédé peut comprendre une étape de chauffage après le dépôt du revêtement électroconducteur en couche minérale de préférence ITO ou à base de ZnO (dopé), chauffage à une température supérieure à 180°C, de préférence comprise entre 250°C et 450°C, en particulier entre 250°C et 350°C, pendant une durée comprise de préférence entre 5 minutes et 120 minutes, en particulier entre 15 et 90 minutes.

Le chauffage permet d'améliorer la Rcarré de la grille et/ou d'abaisser l'absorption de la couche minérale type ITO.

L'invention sera maintenant décrite plus en détails à l'aide d'exemples non limitatifs et de figures.
- La figure 1 est une vue schématique en coupe d'un support électroconducteur pour OLED suivant un premier mode de réalisation de l'invention,
- La figure 1a illustre une vue de détail de la figure 1,
- La figure 1b illustre une vue schématique de dessus de la grille utilisée dans le support de la figure 1 et la figure 1c est une vue schématique de dessus d'une variante de cette grille,
- La figure 1d est une photo prise au microscope électronique à balayage du support électroconducteur (sans revêtement électroconducteur) pour OLED dans un exemple n°1 selon l'invention, montrant la surface haute et un brin de la grille,
- La figure 1e montre le rendement quantique externe d'une OLED faite avec l'exemple n°1 et d'une OLED de comparaison en fonction de l'épaisseur d'HTL,
- La figure 1f est une photo prise au microscope électronique à balayage d'un support électroconducteur (sans revêtement électroconducteur) pour OLED, montrant la surface haute et un brin de la grille dans un premier exemple comparatif,
- La figure 1g est une photo prise au microscope électronique à balayage d'un support électroconducteur (sans revêtement électroconducteur) pour OLED, montrant la surface haute et un brin de la grille dans un deuxième exemple comparatif réalisé par la Demanderesse,
- La figure 1h illustre une vue schématique de détail d'une section d'une cavité de la couche partiellement structurée avec le brin du deuxième exemple comparatif réalisé par la Demanderesse,
- La figure 2 est une vue schématique en coupe d'un support électroconducteur pour OLED suivant un deuxième mode de réalisation de l'invention,
- Les figures 3a à 3g sont des vues schématiques du procédé de fabrication du support électroconducteur de la figure 1,
- La figure 4 est une photo prise au microscope électronique à balayage d'une section d'une cavité de la couche partiellement structurée.

On précise que par souci de clarté les différents éléments des objets représentés ne sont pas reproduits à l'échelle.

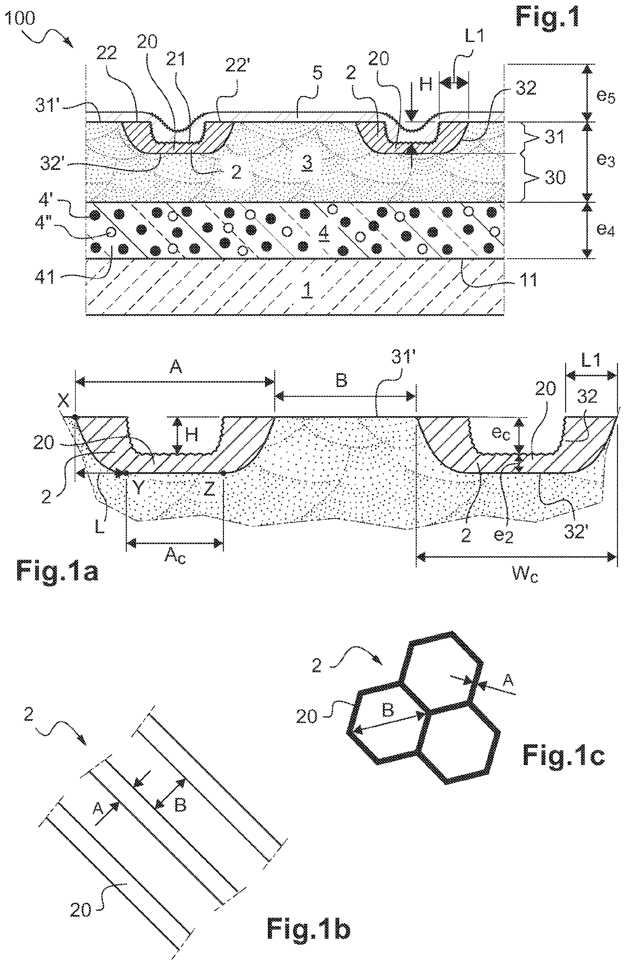

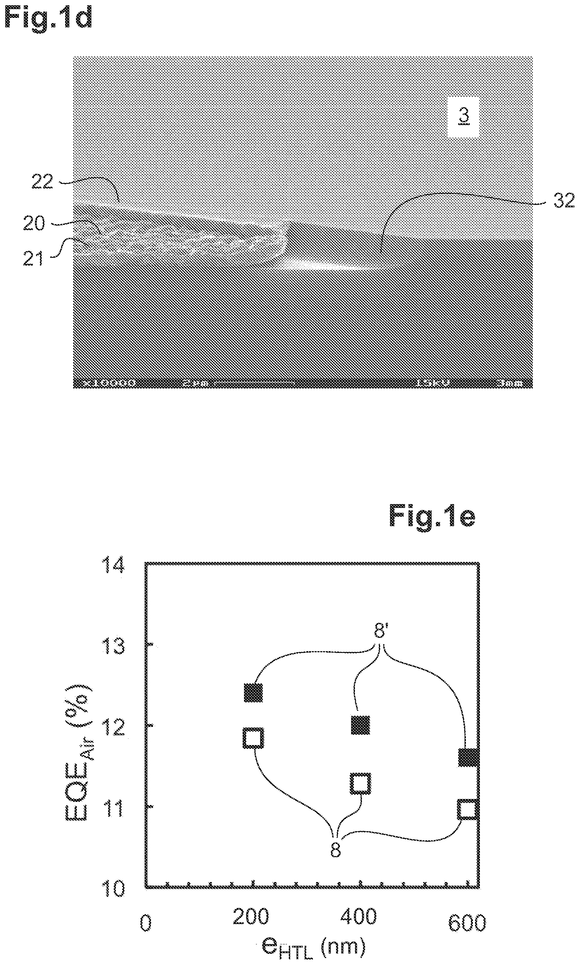

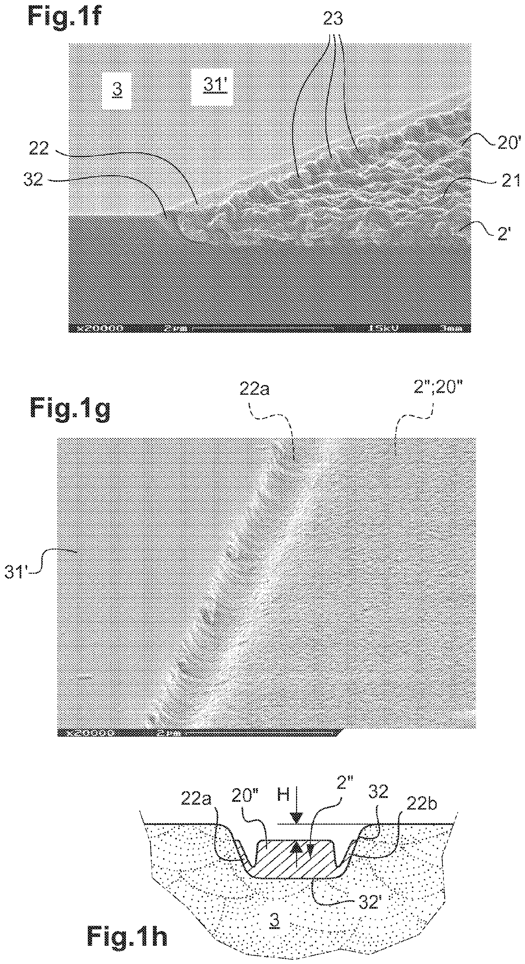

La figure 1, schématique, représente en coupe latérale un support électroconducteur et diffusant 100 pour dispositif électroluminescent organique OLED à émission à travers le substrat (ou « bottom emission » en anglais).

Ce support 100 comporte un substrat verrier 1 plan -ou courbe-, verre organique ou de préférence minéral d'indice de réfraction nₛ de 1,3 à 1,6 - lisse ou même texturé pour être diffusant - avec une première face principale 11, dite première surface, portant dans cet ordre en s'éloignant du substrat :
- une optionnelle couche barrière aux alcalins (non représentée) si verre minéral, ou barrière à l'humidité si verre organique, comme du nitrure de silicium ou du Ti(Zr)Oₓ,
- une couche d'extraction de lumière 41, électriquement isolante, formée par une couche additionnelle diffusante avec des éléments diffusants et de préférence couche minérale, de préférence en matériaux vitreux haut indice d'indice de réfraction n₄ de 1,7 à 2,3 de préférence de 1,80 à 2,10 et en particulier de 1,85 à 2,00, matériaux vitreux comme un émail contenant comme éléments diffusants tels que des particules diffusantes 4' et des pores 4" (ou en variante l'un des deux seulement), couche d'épaisseur e₄ donnée de préférence micronique et même d'au plus 30µm,
- une couche partiellement structurée en épaisseur 3, électriquement isolante, minérale, haut indice, d'indice de réfraction n₃ de 1,7 à 2,3 de préférence de 1,80 à 2,10 et en particulier de 1,85 à 2,00, de préférence un matériau vitreux haut indice, de préférence un émail, d'épaisseur e₃ de préférence micronique même d'au plus 20µm et sans particules diffusantes ajoutées au matériau vitreux haut indice, couvrant la surface de la couche additionnelle diffusante, comportant :
   - une région (continue, non texturée) dite région basse 30, qui est ici directement sur la couche additionnelle diffusante d'épaisseur e'3 donnée (de préférence micronique), couvrant la surface de la couche additionnelle diffusante,
   - une région structurée 31, en relief et en creux, les reliefs définissant une surface haute 31' plane, les cavités ou creux étant délimitées par un fond 32' (définissant une surface basse) et des flancs 32, cavité de hauteur e_{c} prise au milieu de préférence d'au plus 1500nm et supérieure à 200nm les cavités s'étendant selon un arrangement donné (des bandes disjointes, un maillage etc) régulier ou irrégulier, la surface haute étant localement plane,
- une électrode 2, comportant une couche arrangée en grille 20, dite grille métallique, en matériau(x) métallique(s), de préférence monocouche d'argent, la grille étant ici une monocouche formée de brins - autrement dit pistes - 20 ancrés dans les cavités, les brins ayant une largeur A inférieure à 50µm, mieux inférieure ou égale à 30µm (et d'au moins 1µm) et étant espacés d'une distance B inférieure ou égale 5000µm, grille d'épaisseur e2 définie au milieu de la surface de brin d'au moins 100nm et de préférence inférieure à 1500nm, la grille présentant une résistance par carré inférieure à 20Ω/□, et même inférieure à 10 Ω/□, ou à 5Ω/□,
- un revêtement électroconducteur 5, de préférence monocouche, d'épaisseur e₅ inférieure ou égale à 100nm et mieux inférieure ou égale à 60nm, de résistivité ρ₅ inférieure à 20Ω.cm et supérieure à la résistivité de la grille métallique, et est d'indice de réfraction n₅ donné d'au moins 1,55, constitué d'une couche minérale qui est de préférence en ITO (ou en AZO ou GZO, AGZO) sur la grille 2 et la surface haute 31' ou en variante qui est une couche polymérique conductrice haut indice comme le PEDOT/ PSS déposé par voie liquide, de résistivité p1 par exemple de l'ordre de 10⁻¹ Ohm.cm, d'épaisseur de l'ordre de 100nm ou plus.

Pour caractériser les cavités, comme montré en figure 1a (vue de détail de la figure 1), on définit la largeur A_{c} au fond de la cavité et B_{c} la distance entre deux fonds voisins de cavités. e_{c} est la hauteur partant du centre du fond de la cavité.

Les cavités ont des flancs obliques du fait du procédé de gravure humide d'une couche lors de la formation de la couche partiellement structurée détaillé plus tard.

Les flancs sont évasés (s'élargissant en s'éloignant du substrat), on définit une distance horizontale L entre X et Y telle que X étant le point le plus haut du flanc et Y étant le point à l'extrémité du fond de la cavité. On obtient L est supérieure à e_{c}, L≤2e_{c} et même L≤1,4e_{c}.

L'écart H entre la surface haute 31' et la surface de la grille métallique 2 au centre de la cavité est supérieur à 100nm et mieux à 150nm.

Les brins présentent une zone centrale 21 rugueuse du fait du dépôt par argenture et des zones latérales lisses 22, 22' de largeur L1. La largeur de la zone centrale A_{c} est donc égale à A-2L1.

Le revêtement 5 d'ITO est déposé par pulvérisation cathodique magnétron, sa surface est conforme à la surface sous jacente (surface de la couche partiellement structurée, des zones latérales, des zones centrales).

La couche partiellement structurée 3 est plane localement, ne contient pas de particules diffusantes. La couche partiellement structurée ne contient pas de pores, au moins peu de pores ouverts en surface. A tout le moins la couche partiellement structurée ne contient pas de pores susceptible de diffuser la lumière et/ou créant une trop grande rugosité de surface localement.

Pour fabriquer ensuite un dispositif OLED on rajoute un système électroluminescent organique, simple ou multiple jonction (tandem etc), une électrode supérieure réfléchissante (ou semi réfléchissante), notamment métallique par exemple à base d'argent ou d'aluminium.

La figure 1b illustre une vue schématique de dessus de la grille utilisée dans le support 100 de la figure 1. La grille 2 est formée des brins 20 linéaires, disjoints (donc dans des cavités formant des sillons linéaires, disjoints) de largeur A au niveau de la surface haute et de distance B au niveau de la surface haute. La distance entre motifs B correspond à la distance maximale entre des brins voisins.

La figure 1c est une variante de grille avec des brins 20 interconnectés formant des mailles ou motifs fermés par exemple en nid d'abeille ou de toute autre forme géométrique (carré etc) ou non. La distance entre motifs B correspond à la distance maximale entre deux points d'une maille.

Dans un exemple de réalisation n°1 en relation avec la figure 1 on choisit les caractéristiques ci-après.

Le verre 1 est plan, de flou inférieur à 1%, en verre silico-sodo-calcique clair, par exemple verre flotté, d'indice 1,5 environ, par exemple de 0,7mm d'épaisseur et de T_{L} d'au moins 90%.

La couche additionnelle diffusante 4, d'épaisseur e₄ égale 10µm, est un émail haut indice (n₄= 1,95 à λ=550nm) composée d'une matrice verrière riche en bismuth (au moins 55% en poids par exemple et de préférence moins de 85% en poids), de Tg inférieure à 500°C, et contenant des particules diffusantes de TiO₂ (diamètre moyen 400nm) ou en variante de SiO₂ (diamètre moyen 300nm), avec la densité de particules pour le TiO₂ de l'ordre de 5.10⁸particules/mm³ et pour le SiO₂ de 2.10⁶particules/mm³.

La couche partiellement structurée 3 déposée directement sur la couche diffusante 4 est composée de la même matrice riche en bismuth (n₃= 1,95 à λ=550nm) sans rajout de particules diffusantes, d'épaisseur e₃ de 9 à 12µm par exemple 10µm.

L'épaisseur e_{c} est de 500nm. Les cavités de la couche en émail 3 sont obtenues par gravure à l'acide comme détaillé ultérieurement.

La couche partiellement structurée 3 est localement plane. La rugosité de la surface haute 31' est définie par un Ra inférieur à 1nm.

La cuisson au-dessus de Tg (et même celle pour éliminer le médium organique) est par exemple faite une seule fois après le dépôt de la pâte à base de fritte de verre et de particules diffusantes (et un éventuel séchage) et après le dépôt de la même pate de fritte de verre sans particules diffusantes.

La T_{L} de l'ensemble verre 1, couche diffusante 4, et couche partiellement structurée 3, est de 57%, le flou de 85%, l'absorption de moins de 2%.

La grille 2 est une monocouche d'argent déposée directement dans les cavités par argenture. L'argent remplit partiellement les cavités, avec e₂ égale à 200nm environ. H est donc égal à 300nm. Le motif de la grille qui est un maillage est hexagonal. La largeur A égale à 12µm et la distance maximale B de 560µm. Le taux de couverture T est de 4,5%.

La couche d'argent est déposée dans la couche partiellement structurée 3 selon le mode opératoire suivant pour l'épaisseur e2 d'environ 200nm :
- dilution des solutions d'argenture (solutions à diluer fournie par la société DR.-ING. SCHMITT, GMBH Dieselstr. 16, 64807 Dieburg / GERMANY) selon :
   ∘ 100µl de Miraflex®1200 (solution de SnCl₂) dans une fiole de 250cm³ (sol n°1)
   ∘ 200µl de Miraflex® PD (solution de PdCl₂) dans une fiole de 250cm³ (sol n°2)
   ∘ 15 ml de Miraflex®RV (solution de réducteur, gluconate de sodium) dans une fiole de 250cm³ (sol n°3)
   ∘ 15 ml de Miraflex®S (solution de nitrate d'argent) dans une fiole de 250cm³ (sol n°4)
- placement du substrat (avec couches en émail 4, 3) dans un bac dans lequel on verse le contenu de la solution n°1, agitation pendant 1min puis rinçage à l'eau distillée ;
- placement du substrat (avec couches en émail 4,3) dans un deuxième bac dans lequel on verse le contenu de la solution n°2, agitation pendant 1min puis rinçage à l'eau distillée ;
- placement du substrat (avec couches en émail 4,3) dans un dernier bac dans lequel on verse le contenu des solutions n°3 et 4, agitation pendant 2 minutes puis rinçage à l'eau distillée.

Le revêtement électroconducteur 5 est constitué d'une couche d'oxyde d'indium et d'étain ITO de 50nm d'indice de réfraction de 2 environ, de résistivité ρ₅ inférieure à 10⁻¹Ω.cm.

L'ITO est déposé par pulvérisation cathodique magnétron sous mélange d'argon et d'oxygène O₂ /(Ar + O₂) à 1% à une pression de 2 10⁻³ mbar avec une cible céramique en en oxyde d'indium (90% en poids) et d'oxyde d'étain (10% en poids).

La Rcarré de l'ensemble après recuit à 600°C pendant 20min, mesurée par la méthode classique des 4 pointes est de 2,5ohm/carré environ.

La figure 1d est une photo prise au microscope à force atomique de la grille d'argent 2 dans la couche partiellement structurée avant le dépôt du revêtement électroconducteur montrant la surface haute 31 de la couche d'émail 3 partiellement structurée et un brin 20 de la grille avec une zone latérale 22 plane et la zone centrale 21 plus rugueuse. On voit aussi le flanc 32 de la cavité.

La figure 1e montre la dépendance du rendement quantique externe mesuré dans l'air EQEₐᵢᵣ en fonction de l'épaisseur de la couche HTL d'une OLED faite avec l'exemple n°1 (courbe 8) et d'une OLED de comparaison (courbe 8').

L'OLED de comparaison est réalisée par la Demanderesse à partir du même verre et de la même couche additionnelle diffusante, surmontée d'une couche non structurée de matière et d'épaisseur identique à la couche partiellement structurée et avec comme électrode une couche d'ITO identique à celle du revêtement 5 et d'épaisseur égale à 50nm et de R carré de 100ohm/carré donc bien supérieure à celle de l'OLED de l'exemple n°1.

Le système électroluminescent comporte :
- une couche HTL d'épaisseur variable (entre 200 et 600 nm environ)
-.une couche EBL (electron blocking layer) de 10 nm
- une couche émettant dans l'orange de 10 nm
- une couche émettant dans le bleu de 25 nm
- une couche HBL (hole blocking layer) de10 nm
- une couche ETL (electron transport layer) de 40 nm.

La cathode est une couche d'aluminium de 100 nm.

EQE_{Air} est mesuré à l'intérieur d'une sphère intégrante. EQE_{Air} de l'OLED selon l'invention est satisfaisant (entre 11% et 12%), et est quasi égal à celui de l'OLED de comparaison. La différence de l'ordre de 5% est due à l'occultation de la surface par la grille d'argent (taux de couverture T de 4.5%). Par contre, en raison de la plus faible Rsq de l'anode de comparaison, les OLEDs réalisées dans l'exemple n°1 ont des efficacités lumineuses supérieures de l'ordre de 20% à celles des OLEDs de comparaison. Par ailleurs, les OLEDs réalisées dans l'exemple n°1 ont des EQE_{Air} supérieures à celles d'OLEDs réalisées à partir d'un verre (sans couche d'extraction de lumière) et d'une électrode à base d'ITO dont l'EQE_{Air} est autour de 7,5 à 8%.

La figure 1f est une photo prise au microscope électronique à balayage montrant un brin 20' d'une grille 2' obtenue par argenture mais dont la zone centrale 21 affleure de moins de 100nm de la surface haute 31' de la couche 'émail partiellement structurée 3, exemple réalisé en tant qu'exemple comparatif par la Demanderesse.

On observe l'apparition de protubérances 23 (ici en continu) de hauteur de l'ordre de 50nm le long du bord intérieur de la surface latérale lisse 22 et du bord extérieur de la surface centrale rugueuse 21. Ces protubérances 23 génèrent des courants de fuite.

La figure 1g est une photo prise au microscope électronique à balayage, montrant le dessus d'un brin 20" d'une grille 2" obtenue par pulvérisation cathodique magnétron au lieu de l'argenture, et montrant la surface haute 31 de la couche 3. L'argent est déposé par pulvérisation cathodique magnétron sous argon à une pression de 8 10⁻³ mbar avec une cible en argent.

Par effet d'ombrage due à la couche de masquage, les zones latérales 22a du brin sont en cuvette. Ces cuvettes génèrent des courants de fuite.

Ainsi, la figure 1h montre en vue schématique de détail et de coupe le profil d'un brin 20" de ce type de grille en argent 2", brin dans une cavité de la couche partiellement structurée 3. Les zones latérales 22a et 22b créent des ruptures de morphologie génèrant les courants de fuite.

La figure 2 représente schématiquement en coupe latérale un support électroconducteur 2000 pour dispositif électroluminescent organique OLED à émission à travers le substrat (ou « bottom emission » en anglais) dans un deuxième mode de réalisation de l'invention.

Seules les modifications par rapport au support 100 du premier mode sont détaillées ci-après.

La couche d'extraction de lumière 42 est formée par la première surface du verre 1 qui est diffusante, rugueuse. Ainsi, la couche partiellement structurée 3 est directement sur la première surface diffusante du verre.

Dans un exemple de réalisation n°2 en relation avec cette figure 2 on choisit les caractéristiques ci-après.

La rugosité 42 de la première surface diffusante 11 est obtenue par un dépolissage du verre, grâce par exemple à de l'acide fluorhydrique. Un exemple de substrat rugueux est le verre dénommé Satinovo® Mate produit par la société La Veneciana de Saint-Gobain. Les excroissances du substrat dépoli sont par exemple sensiblement pyramidales, réparties de manière aléatoire, diffusant la lumière de manière isotrope.

Le tableau ci-après donne les paramètres de rugosité Ra, Rz et le flou (haze).

| Ra (µm) | Rz (µm) | Haze (%) |
|---|---|---|
| 2,40 | 16,9 | 88,0 |

Pour la couche partiellement structurée 3, haut indice, on choisit l'émail tel que décrit pour la couche de l'exemple 1 et d'épaisseur e₃ de 20µm.

Alternativement on peut choisir une surface diffusante obtenue par abrasion telle que décrite dans les exemples 1 à 5 de la demande WO2014/048927.

Les figure 3a à 3g sont des vues schématiques (non à l'échelle) du procédé de fabrication de la couche partiellement structurée par gravure acide, et de fabrication de la grille en argent par argenture en relation avec la figure 1.

La première étape illustrée en figure 3a consiste, à partir du verre 1 revêtu de la couche d'extraction de lumière 4 formée par la couche additionnelle diffusante sur le substrat qui est un matériau minéral avec des particules diffusantes :
- à former sur la couche d'extraction de lumière, une couche 3a haut indice, qui comporte le matériau vitreux (émail de préférence) avec ledit indice de réfraction n₃,
- à appliquer une couche 60 d'un matériau de masquage à l'état liquide, ici une résine photo sensible positive, résine classique AZ1505, sur la couche 3a.

La photorésine est ensuite cuite à 100°C pendant 20min dans un four convectif. L'épaisseur de la photorésine est de 800nm.

La deuxième étape illustrée en figure 3b consiste en la génération du motif de photorésine. On applique pour ce faire sur la résine 60 un masque de photolithographie 70 avec des discontinuités 71 et on irradie la résine 60 aux UV avec une lampe Hg, à 20mW/cm² (à 365nm), pendant 10 secondes au travers des discontinuités, dans les zones destinées à devenir des ouvertures traversantes selon un arrangement irrégulier ou régulier, en bandes disjointes (parallèles) ou interconnectées pour un maillage.

La troisième étape illustrée en figure 3c consiste en la création des ouvertures traversantes dans la photorésine 60. Les zones irradiées sont supprimées par dissolution dans une solution spécifique de développement à base d'hydroxyde de tétraméthylammonium (TMAH en anglais) et rincées à l'eau désionisée, formant ainsi des ouvertures traversantes à travers la photorésine. Les flancs 61 de la photorésine délimitant les ouvertures traversantes sont obliques et évasés en s'éloignant du verre. Ainsi, au niveau de la surface externe ou supérieure 63 de la photorésine 60, la largeur de chaque ouverture traversante est supérieure à la largeur W0 au niveau de la surface haute 31'.

Alternativement, on peut utiliser une résine photosensible négative et un masque de photogravure inverse (retrait des zones non irradiées pour former les ouvertures).

La quatrième étape illustrée en figure 3d consiste en la création des cavités dans la couche continue diélectrique et haut indice 3a telle que la couche en émail. On préfère former la couche partiellement structurée par une gravure humide plutôt que sèche, par exemple une gravure à l'acide, à température ambiante. La résine 60 choisie est donc résistante à la solution de gravure qui est de l'acide acétique de pH 2,1. La profondeur de gravure est alors contrôlée par la durée de gravure ici de 35nm.min⁻¹. La gravure forme des cavités de profondeur e_{c} avec des flancs 32 obliques, courbes, évasés en s'éloignant du verre 1.

La solution de gravure, ici acide, attaque (creuse) dans toutes les directions : verticalement et latéralement.

Le profil de gravure est en cuvette. Chaque cavité est de largeur Wc plus grande que la largeur W0, laissant des portions de surface de photorésine positive 62, 62' dépassantes de la surface haute en regard de la cavité, dites surfaces internes. Les surfaces internes 62,62' sont de largeur L0 sensiblement égale à L. Le fond 32' des cavités est plat.

La figure 4 est une photo prise au MEB montrant une vue partielle et de coupe de la couche d'émail partiellement structurée 3 et d'une cavité avec le fond 32' et un flanc courbe 32.

La cinquième étape illustrée en figure 3e consiste en le dépôt du matériau de grille 2, par voie liquide et plus précisément autocatalytique, ainsi de préférence par argenture. Le dépôt est réalisé au travers des ouvertures 61 de la photorésine 60 (résistant à la gravure acide), dans les cavités pour les remplir partiellement. L'argent se dépose, dans le fond des cavités, sur les flancs des cavités, sur les surfaces internes 62, 62' de la photorésine, sur les flancs de la photorésine (et est absent de la surface haute de la couche 3) et sur la surface supérieure ou dite externe discontinue 63.

Plus précisément, l'argenture remplit partiellement chaque cavité et se dépose dans le fond, sur les flancs et entièrement sur les surfaces internes 62,62' de la couche de masquage, formant ainsi les zones latérales de brin 23, 23' affleurant la surface haute et moins rugueuses que la zone centrale de brin 24 en regard de l'ouverture traversante. La largeur L1 de chaque zone latérale 22,23' est à peu près égale à L0+e2.

Des exemples de paramètres de rugosité des zones centrales et des zones latérales planes sont consignés dans le tableau suivant en fonction de l'épaisseur e₂.

| Surface du brin | e₂ (nm) | Rq (nm) | Rmax (nm) |
|---|---|---|---|
| Zones latérales | 200 | 1,5 | 8 |
| Zone centrale | 200 | 20 | 200 |
| Zones latérales | 300 | 2 | 10 |
| Zone centrale | 300 | 30 | 300 |
| Zone latérales | 450 | 2 | 10 |
| Zone centrale | 450 | 35 | 450 |

La sixième étape illustrée en figure 3f consiste en le retrait de de la photorésine par voie liquide avec un solvant acétone et utilisation d'ultrasons.

La septième étape illustrée en figure 3g consiste en le dépôt par pulvérisation cathodique du revêtement électroconducteur 5 en ITO ou en AZO, GZO ou AGZO. Alternativement il s'agit d'un dépôt par voie liquide de ces matériaux ou même d'un polymère conducteur.

## Revendications

1. Support électroconducteur (100 à 200) pour OLED comportant dans cet ordre:
- un substrat verrier, verre organique ou minéral, (1) d'indice de réfraction n₁ de 1,3 à 1,6, avec une première face principale (11), dite première surface,
- une électrode, portée par le substrat verrier et du côté de la première surface (11), électrode qui comporte une couche arrangée en grille (2), dite grille métallique, en matériau(x) métallique(s) présentant une résistance par carré inférieure à 20 Ω/□, d'épaisseur e2 d'au moins 100nm, la grille étant formée de brins (20), les brins ayant une largeur A inférieure ou égale à 50µm et étant séparés par une distance entre brins B inférieure ou égale 5000µm, ces brins étant séparés par une pluralité de domaines non électroconducteurs (31) électriquement isolant d'indice de réfraction supérieur à 1,65, **caractérisé en ce que** du côté de la première surface (11), le support comporte :
- une couche d'extraction de lumière (41 à 42), électriquement isolante, sous la grille métallique (2)
- une couche partiellement structurée (3) en épaisseur, électriquement isolante, de composition donnée, d'indice de réfraction n₃ de 1,7 à 2,3, qui est sur la couche d'extraction de lumière, couche partiellement structurée formée :
- d'une région structurée (31) la plus éloignée de la couche d'extraction de lumière, avec des cavités contenant la grille métallique, région incluant les domaines non électroconducteurs,
- d'une autre région (30), dite région basse, sous la grille métallique et sur la couche d'extraction de lumière,
et **en ce que** la grille sous affleure la surface dite surface haute (31') des domaines non électroconducteurs (31) et l'écart H entre la surface haute (31') et la surface de la grille métallique (2) est supérieur à 100nm, H étant mesuré entre le milieu de la surface de brin et la surface haute et **en ce que** les brins (2) présentent suivant leur longueur une zone centrale (21) entre des zones latérales (22, 22') qui affleurent la surface haute (31').

2. Support électroconducteur (100 à 200) selon l'une des revendications précédentes **caractérisé en ce que** H est supérieur à 150nm et de préférence inférieur à 500nm.

3. Support électroconducteur (100 à 200) selon l'une des revendications précédentes **caractérisé en ce que** la surface de brin (20) est dénuée de protubérances de hauteur supérieure à 10nm longeant les bords intérieurs des zones latérales (22, 22').

4. Support électroconducteur (100 à 200) selon l'une des revendications précédentes **caractérisé en ce que** la grille métallique (2, 20) est obtenue par dépot autocatalytique et de préférence par argenture.

5. Support électroconducteur (100 à 200) selon l'une des revendications précédentes **caractérisé en ce que** la rugosité de surface de la zone centrale (21) est supérieure à la rugosité de surface des zones latérales (22, 22'), et le paramètre de rugosité Rq des zones latérales (22, 22') est d'au plus 5nm.

6. Support électroconducteur (100 à 200) selon l'une des revendications précédentes **caractérisé en ce que** les zones latérales (22, 22') sont de largeur L1, L1 étant supérieure à la hauteur e_{c} des cavités et L1≤2e_{c}.

7. Support électroconducteur (100 à 200) selon l'une des revendications précédentes **caractérisé en ce que** la grille métallique (2, 20), de préférence en argent, présente un taux de couverture T inférieur à 25% ou inférieur à 10%, et même à 6%.

8. Support électroconducteur (100 à 200) selon l'une des revendications précédentes **caractérisé en ce que** l'épaisseur e₂ de la grille métallique (2, 20) est inférieure à 1500nm, de préférence dans une gamme allant de 100nm à 1000nm et en particulier dans une gamme allant de 200nm à 800nm, la largeur A est inférieure à 30µm, de préférence dans une gamme allant de 1,5µm à 20µm.

9. Support électroconducteur (100 à 200) selon l'une des revendications précédentes **caractérisé en ce que** le ou les matériaux de la grille métallique (20) sont choisis dans le groupe formé par l'argent, le cuivre, le nickel, et les alliages à base ces métaux et est de préférence à base d'argent.

10. Support électroconducteur (100 à 200) selon l'une des revendications précédentes **caractérisé en ce que** les cavités (32, 32'), de hauteur e_{c} supérieure à 200nm, sont délimitées par des flancs (32) évasés, s'élargissant en s'éloignant du substrat verrier, avec une distance horizontale L supérieure à e_{c} et avec L≤2e_{c}.

11. Support électroconducteur (100 à 200) selon l'une des revendications précédentes **caractérisé en ce que** la région structurée (31), et de préférence la région basse (30), est dénuée de particules diffusantes.

12. Support électroconducteur (100 à 200) selon l'une des revendications précédentes **caractérisé en ce que** la couche partiellement structurée (3) est en matériau vitreux, de préférence un émail.

13. Support électroconducteur (100 à 200) selon l'une des revendications précédentes **caractérisé en ce que** le substrat (1) est de préférence en verre minéral, la couche d'extraction de lumière comporte une couche additionnelle diffusante (41) dont la matière comporte un matériau vitreux, de préférence un émail et avec des éléments diffusants (4', 4"), et la composition de la couche partiellement structurée (3) comporte un matériau vitreux, de préférence un émail, composition notamment identique à la matière de la couche additionnelle diffusante, et/ou **en ce qu'**une première surface diffusante du substrat (42), de préférence en verre minéral, fait partie, voire constitue, la couche d'extraction de lumière et la composition de la couche partiellement structurée (3) comporte un matériau vitreux, de préférence un émail.

14. Support électroconducteur (100 à 200) selon l'une des revendications précédentes **caractérisé en ce qu'**un revêtement électroconducteur (5) couvre, de préférence directement, la surface haute (31') et la grille métallique (2) qui est de préférence en argent, notamment revêtement électroconducteur d'épaisseur e₅ inférieure ou égale à 500nm, de résistivité ρ₅ inférieure à 20Ω.cm et supérieure à la résistivité de la grille métallique, et qui est d'indice de réfraction n₅ d'au moins 1,55.

15. Support électroconducteur (100 à 200) selon la revendication précédente **caractérisé en ce que** le revêtement électroconducteur (5) comprend une couche minérale d'indice de réfraction nₐ compris entre 1,7 et 2,3, d'épaisseur inférieure à 150nm, en oxyde transparent électroconducteur, de préférence à base d'oxyde d'indium et d'étain ou à base d'oxyde de zinc.

16. Support électroconducteur selon l'une des revendications 14 ou 15 **caractérisé en ce que** le revêtement électroconducteur comprend, au moins en dernière couche la plus éloignée du substrat, une couche organique, en polymère(s) électroconducteur(s), d'épaisseur submicronique, comme le PEDOT ou PEDOT:PSS d'indice de réfraction n_{b} d'au moins 1,55.

17. Support électroconducteur selon l'une des revendications 14 ou 15 **caractérisé en ce qu'**il comporte un système électroluminescent organique déposé sur le revêtement électroconducteur (5) incluant éventuellement une couche de transport de trous HTL ou d'injection de trous HIL.

18. Dispositif électroluminescent organique incorporant un support électroconducteur (100 à 200) selon l'une quelconque des revendications précédentes, l'électrode avec la grille métallique formant l'électrode dite inférieure, la plus proche du substrat.

19. Procédé de fabrication du support électroconducteur (100 à 200) selon l'une des revendications précédentes de support électroconducteur **caractérisé en ce qu'**il comporte les étapes suivantes dans cet ordre:
- la fourniture du substrat comportant :
- la couche d'extraction de lumière (4) de préférence formée par la première surface diffusante du substrat et/ou formée par une couche additionnelle diffusante sur la première surface du substrat,
- sur la couche d'extraction de lumière, une couche dite haut indice (3a), en la composition d'indice de réfraction n₃, de préférence exempte de particules diffusantes, de préférence couche haut indice planarisant la couche d'extraction de lumière,
- la formation des cavités dans la couche haut indice (3a), formant ainsi la couche partiellement structurée (3), formation comportant :
- la réalisation sur la couche haut indice (3a) d'une couche de masquage discontinue avec un arrangement d'ouvertures traversantes donné, et avec des flancs,
- la gravure humide de la couche haut indice (3a) au travers des ouvertures traversantes de la couche de masquage, les flancs de la couche de masquage dépassant des flancs des cavités et définissant ainsi des portions de surfaces dites surfaces internes (62, 62') de la couche de masquage en regard des cavités,
- la formation de la grille métallique (2) comprenant un dépôt par voie liquide, de préférence autocatalytique, d'un premier matériau métallique de la grille remplissant partiellement les cavités, le premier matériau se déposant dans le fond des cavités, sur les flancs des cavités et entièrement sur les surface internes (62, 62') de la couche de masquage (60), formant ainsi les zones latérales de brin (22, 22') affleurant la surface haute et moins rugueuses que les zones centrales de brin (21)
- le retrait de la couche de masquage.

20. Procédé de fabrication du support électroconducteur (100 à 200) selon la revendication précédente **caractérisé en ce que** le retrait de la couche de masquage ne crée pas de protubérances de hauteur d'au moins 10nm sur la surface de la grille métallique.

21. Procédé de fabrication du support électroconducteur (100 à 200) selon l'une des revendications précédentes **caractérisé en ce que** le dépôt par voie liquide est une argenture et de préférence la grille (2) est une monocouche.

22. Procédé de fabrication du support électroconducteur (100 à 200) selon l'une des revendications précédentes de procédé **caractérisé en ce que** la couche de masquage (60) est une photorésine.

23. Procédé de fabrication du support conducteur (100 à 200) selon l'une des revendications précédentes de procédé **caractérisé en ce qu'**il comprend après le retrait de la couche de masquage, le dépôt par pulvérisation cathodique du revêtement électroconducteur (5) à base d'ITO ou d'oxyde de zinc dopé ou le dépôt par voie liquide du revêtement électroconducteur polymérique.

24. Procédé de fabrication du support électroconducteur (100 à 200) selon l'une des revendications précédentes de procédé **caractérisé en ce que** la couche haut indice (30) comporte un émail, notamment obtenue à partir d'une première composition à base de fritte de verre et de préférence la couche additionnelle diffusante comporte un émail obtenu à partir d'une deuxième composition à base de fritte de verre, de préférence identique à la première composition et comportant des particules diffusantes.

25. Procédé de fabrication du support électroconducteur (100 à 200) selon l'une des revendications précédentes de procédé, **caractérisé par le fait qu'**il comprend une étape de chauffage avant le dépôt du revêtement électroconducteur à une température supérieure à 180°C, de préférence comprise entre 250°C et 450°C, en particulier entre 250°C et 350°C, pendant une durée comprise de préférence entre 5 minutes et 120 minutes, en particulier entre 15 et 90 minutes et/ou en ce qu'il comprend le dépôt du revêtement électroconducteur, en couche minérale, de préférence ITO, et un chauffage par la suite à une température supérieure à 180°C, de préférence comprise entre 250°C et 450°C, en particulier entre 250°C et 350°C, pendant une durée comprise de préférence entre 5 minutes et 120 minutes, en particulier entre 15 et 90 minutes.

## Patentansprüche

1. Elektrisch leitfähiger Träger (100 bis 200) für OLED, umfassend in dieser Reihenfolge:
- ein Glassubstrat, organisches oder Mineralglas (1), mit einem Brechungsindex n₁ von 1,3 bis 1,6 mit einer ersten Hauptseite (11), erste Oberfläche genannt,
- eine Elektrode, die vom Glassubstrat und auf der Seite der ersten Oberfläche (11) getragen wird, wobei die Elektrode eine als Gitter (2) angeordnete Schicht, Metallgitter genannt, aus einem oder mehreren metallischen Materialien umfasst, die einen Flächenwiderstand von weniger als 20 Ω/□ aufweist, mit einer Dicke e2 von mindestens 100nm, wobei das Gitter aus Drähten (20) gebildet ist, wobei die Drähte eine Breite A kleiner oder gleich 50µm haben und durch einen Abstand B zwischen Drähten kleiner oder gleich 5000µm getrennt sind, wobei diese Drähte durch eine Vielzahl von elektrisch nicht leitfähigen, elektrisch isolierenden Bereichen (31) mit einem Brechungsindex von mehr als 1,65 getrennt sind,
**dadurch gekennzeichnet, dass** der Träger auf der Seite der ersten Oberfläche (11) umfasst:
- eine elektrisch isolierende Lichtauskopplungsschicht (41 bis 42), unter dem Metallgitter (2)
- eine elektrisch isolierende, in der Dicke teilstrukturierte Schicht (3) mit gegebener Zusammensetzung mit einem Brechungsindex n₃ von 1,7 bis 2,3, die auf der Lichtauskopplungsschicht ist, wobei die teilstrukturierte Schicht gebildet ist aus:
- einer strukturierten Region (31), die am weitesten von der Lichtauskopplungsschicht entfernt ist, mit Kavitäten, die das Metallgitter enthalten, wobei die Region elektrisch nicht leitfähige Bereiche beinhaltet,
- einer weiteren Region (30), untere Region genannt, unter dem Metallgitter und auf der Lichtauskopplungsschicht,
und **dadurch gekennzeichnet, dass** das Gitter unterbündig zur oberen Oberfläche (31') genannten Oberfläche der elektrisch nicht leitfähigen Bereiche (31) ist und der Abstand H zwischen der oberen Oberfläche (31') und der Oberfläche des Metallgitters (2) größer als 100nm ist, wobei H zwischen der Mitte der Drahtoberfläche und der oberen Oberfläche gemessen wird, und dadurch, dass die Drähte (2) entlang ihrer Länge einen zentralen Bereich (21) zwischen den seitlichen Bereichen (22, 22') aufweisen, die bündig zur oberen Oberfläche (31') sind.

2. Elektrisch leitfähiger Träger (100 bis 200) nach einem der vorhergehenden Ansprüche, **dadurch gekennzeichnet, dass** H größer als 150nm und bevorzugt kleiner als 500nm ist.

3. Elektrisch leitfähiger Träger (100 bis 200) nach einem der vorhergehenden Ansprüche, **dadurch gekennzeichnet, dass** die Drahtoberfläche (20) frei von Protuberanzen mit einer Höhe von mehr als 10nm entlang der inneren Ränder der seitlichen Bereiche (22, 22') ist.

4. Elektrisch leitfähiger Träger (100 bis 200) nach einem der vorhergehenden Ansprüche, **dadurch gekennzeichnet, dass** das Metallgitter (2, 20) durch stromlose Abscheidung und bevorzugt durch Versilbern erhalten wird.

5. Elektrisch leitfähiger Träger (100 bis 200) nach einem der vorhergehenden Ansprüche, **dadurch gekennzeichnet, dass** die Oberflächenrauheit des zentralen Bereichs (21) größer als die Oberflächenrauheit der seitlichen Bereiche (22, 22') ist und der Rauheitsparameter Rq der seitlichen Bereiche (22, 22') höchstens 5nm beträgt.

6. Elektrisch leitfähiger Träger (100 bis 200) nach einem der vorhergehenden Ansprüche, **dadurch gekennzeichnet, dass** die seitlichen Bereiche (22, 22') eine Breite L1 haben, wobei L1 größer als die Höhe e_{c} der Kavitäten ist und L1≤2e_{c}.

7. Elektrisch leitfähiger Träger (100 bis 200) nach einem der vorhergehenden Ansprüche, **dadurch gekennzeichnet, dass** das Metallgitter (2, 20), bevorzugt aus Silber, einen Überdeckungsgrad T von weniger als 25% oder weniger als 10% und sogar als 6% aufweist.

8. Elektrisch leitfähiger Träger (100 bis 200) nach einem der vorhergehenden Ansprüche, **dadurch gekennzeichnet, dass** die Dicke e₂ des Metallgitters (2, 20) kleiner als 1500nm ist, bevorzugt in einem Wertebereich von 100nm bis 1000nm und insbesondere in einem Wertebereich von 200nm bis 800nm, und die Breite A kleiner als 30µm ist, bevorzugt in einem Wertebereich von 1,5µm bis 20µm.

9. Elektrisch leitfähiger Träger (100 bis 200) nach einem der vorhergehenden Ansprüche, **dadurch gekennzeichnet, dass** das oder die Materialien des Metallgitters (20) aus der Gruppe gewählt werden, die aus Silber, Kupfer, Nickel und den Legierungen auf der Basis dieser Metalle und bevorzugt auf Silberbasis gebildet wird.

10. Elektrisch leitfähiger Träger (100 bis 200) nach einem der vorhergehenden Ansprüche, **dadurch gekennzeichnet, dass** die Kavitäten (32, 32') mit einer Höhe e_{c} von mehr als 200nm durch aufgeweitete Flanken (32) begrenzt sind, die mit zunehmender Entfernung vom Glassubstrat weiter werden, mit einem horizontalen Abstand L größer als e_{c} und mit L≤2e_{c}.

11. Elektrisch leitfähiger Träger (100 bis 200) nach einem der vorhergehenden Ansprüche, **dadurch gekennzeichnet, dass** die strukturierte Region (31), und bevorzugt die untere Region (30), frei von Streupartikeln ist.

12. Elektrisch leitfähiger Träger (100 bis 200) nach einem der vorhergehenden Ansprüche, **dadurch gekennzeichnet, dass** die teilstrukturierte Schicht (3) aus glasartigem Material, bevorzugt einem Email, ist.

13. Elektrisch leitfähiger Träger (100 bis 200) nach einem der vorhergehenden Ansprüche, **dadurch gekennzeichnet, dass** das Substrat (1) bevorzugt aus Mineralglas ist, die Lichtauskopplungsschicht eine zusätzliche Streuschicht (41) umfasst, deren Material ein glasartiges Material umfasst, bevorzugt ein Email und mit streuenden Elementen (4', 4"), und die Zusammensetzung der teilstrukturierten Schicht (3) ein glasartiges Material, bevorzugt ein Email, umfasst, dessen Zusammensetzung insbesondere identisch zum Material der zusätzlichen Streuschicht ist, und/oder dadurch, dass ein erste streuende Oberfläche des Substrats (42), bevorzugt aus Mineralglas, Teil der Lichtauskopplungsschicht ist oder diese sogar bildet, und die Zusammensetzung der teilstrukturierten Schicht (3) ein glasartiges Material, bevorzugt ein Email, umfasst.

14. Elektrisch leitfähiger Träger (100 bis 200) nach einem der vorhergehenden Ansprüche, **dadurch gekennzeichnet, dass** ein elektrisch leitfähiger Überzug (5) die obere Oberfläche (31') und das Metallgitter (2), das bevorzugt aus Silber ist, bevorzugt direkt, bedeckt, wobei der elektrisch leitfähige Überzug insbesondere eine Dicke e₅ kleiner oder gleich 500nm, einen spezifischen Widerstand ρ₅ kleiner als 20Ω.cm und größer als der spezifische Widerstand des Metallgitters und einen Brechungsindex n₅ von mindestens 1,55 aufweist.

15. Elektrisch leitfähiger Träger (100 bis 200) nach dem vorhergehenden Anspruch, **dadurch gekennzeichnet, dass** der elektrisch leitfähige Überzug (5) eine mineralische Schicht mit einem Brechungsindex nₐ zwischen 1,7 und 2,3 mit einer Dicke von weniger als 150nm aus elektrisch leitfähigem transparentem Oxid, bevorzugt auf der Basis von Indium-Zinn-Oxid oder auf der Basis von Zinkoxid, umfasst.

16. Elektrisch leitfähiger Träger nach einem der Ansprüche 14 oder 15, **dadurch gekennzeichnet, dass** der elektrisch leitfähige Überzug, zumindest als letzte, am weitesten vom Substrat entfernte Schicht, eine organische Schicht aus einem oder mehreren elektrisch leitfähigen Polymeren mit einer Dicke im Submikrometerbereich wie PEDOT oder PEDOT:PSS mit einem Brechungsindex n_{b} von mindestens 1,55 umfasst.

17. Elektrisch leitfähiger Träger nach einem der Ansprüche 14 oder 15, **dadurch gekennzeichnet, dass** er ein organisches lichtemittierendes System umfasst, das auf den elektrisch leitfähigen Überzug (5) aufgebracht ist, beinhaltend gegebenenfalls eine Lochleitungsschicht HTL oder eine Lochinjektionsschicht HIL.

18. OLED mit einem elektrisch leitfähigen Träger (100 bis 200) nach einem der vorhergehenden Ansprüche, wobei die Elektrode mit dem Metallgitter die sogenannte untere, dem Substrat nächstgelegene Elektrode bildet.

19. Verfahren zur Herstellung des elektrisch leitfähigen Trägers (100 bis 200) nach einem der vorhergehenden Ansprüche, **dadurch gekennzeichnet, dass** es die folgenden Schritte in dieser Reihenfolge umfasst:
- Lieferung des Substrats, umfassend:
- die Lichtauskupplungsschicht (4), die bevorzugt aus der ersten streuenden Oberfläche des Substrats gebildet ist und/oder aus einer zusätzlichen Streuschicht auf der ersten Oberfläche des Substrats gebildet ist,
- auf der Lichtauskopplungsschicht eine sogenannte Hochindexschicht (3a) in der Zusammensetzung mit dem Brechungsindex n₃, bevorzugt frei von Streupartikeln, bevorzugt eine Hochindexschicht, die die Lichtauskopplungsschicht planarisiert,
- die Bildung der Kavitäten in der Hochindexschicht (3a), die somit die teilstrukturierte Schicht (3) bildet, wobei die Bildung umfasst:
- die Ausführung einer diskontinuierlichen Maskierungsschicht mit einer gegebenen Anordnung aus durchgehenden Öffnungen und mit Flanken auf der Hochindexschicht (3a),
- das Nassätzen der Hochindexschicht (3a) durch die durchgehenden Öffnungen der Maskierungsschicht hindurch, wobei die Flanken der Maskierungsschicht die Flanken der Kavitäten überragen und so Oberflächenabschnitte, innere Oberflächen (62, 62') genannt, der Maskierungsschicht gegenüber den Kavitäten definieren,
- Bildung des Metallgitters (2), umfassen ein Abscheiden auf flüssigem Weg, bevorzugt stromlos, eines ersten metallischen Materials des Gitters, das die Kavitäten teilweise füllt, wobei sich das erste Material im Boden der Kavitäten, auf den Flanken der Kavitäten und vollständig auf den inneren Oberflächen (62, 62') der Maskierungsschicht (60) niederschlägt und so die seitlichen Drahtbereiche (22, 22') bildet, die in Bezug auf die obere Oberfläche bündig und weniger rau als die zentralen Drahtbereiche (21) sind
- das Entfernen der Maskierungsschicht.

20. Verfahren zur Herstellung des elektrisch leitfähigen Trägers (100 bis 200) nach dem vorhergehenden Anspruch, **dadurch gekennzeichnet, dass** das Entfernen der Maskierungsschicht keine Protuberanzen mit einer Höhe von mindestens 10nm auf der Oberfläche des Metallgitters verursacht.

21. Verfahren zur Herstellung des elektrisch leitfähigen Trägers (100 bis 200) nach einem der vorhergehenden Ansprüche, **dadurch gekennzeichnet, dass** das Abscheiden auf flüssigem Weg eine Versilberung ist und das Gitter (2) bevorzugt einschichtig ist.

22. Verfahren zur Herstellung des elektrisch leitfähigen Trägers (100 bis 200) nach einem der vorhergehenden Verfahrensansprüche, **dadurch gekennzeichnet, dass** die Maskierungsschicht (60) ein Fotolack ist.

23. Verfahren zur Herstellung des elektrisch leitfähigen Trägers (100 bis 200) nach einem der vorhergehenden Verfahrensansprüche, **dadurch gekennzeichnet, dass** es nach dem Entfernen der Maskierungsschicht die Abscheidung durch kathodische Zerstäubung des elektrisch leitfähigen Überzugs (5) auf der Basis von ITO oder von dotiertem Zinkoxid oder die Abscheidung auf flüssigem Weg des elektrisch leitfähigen polymerischen Überzugs umfasst.

24. Verfahren zur Herstellung des elektrisch leitfähigen Trägers (100 bis 200) nach einem der vorhergehenden Verfahrensansprüche, **dadurch gekennzeichnet, dass** die Hochindexschicht (30) ein Email umfasst, das insbesondere ausgehend von einer ersten Zusammensetzung auf der Basis von Glasfritte erhalten wird, und die zusätzliche Streuschicht bevorzugt ein Email umfasst, das ausgehend von einer zweiten Zusammensetzung auf der Basis von Glasfritte erhalten wird, die bevorzugt identisch zu der ersten Zusammensetzung ist und Streupartikel umfasst.

25. Verfahren zur Herstellung des elektrisch leitfähigen Trägers (100 bis 200) nach einem der vorhergehenden Verfahrensansprüche, **dadurch gekennzeichnet, dass** es einen Schritt des Erhitzens vor dem Aufbringen des elektrisch leitfähigen Überzugs auf eine Temperatur über 180°C, bevorzugt zwischen 250°C und 450°C, insbesondere zwischen 250°C und 350°C, während einer Dauer von bevorzugt zwischen 5 Minuten und 120 Minuten, insbesondere zwischen 15 und 90 Minuten, umfasst und/oder dadurch, dass es die Abscheidung des elektrisch leitfähigen Überzugs als mineralische Schicht, bevorzugt ITO, und ein anschließendes Erhitzen auf eine Temperatur über 180°C, bevorzugt zwischen 250°C und 450°C, insbesondere zwischen 250°C und 350°C, während einer Dauer von bevorzugt zwischen 5 Minuten und 120 Minuten, insbesondere zwischen 15 und 90 Minuten, umfasst.

## Claims

1. Electrically conductive OLED carrier (100 to 200) comprising in this order:
- an organic or mineral glass glazing substrate (1) of refractive index n₁ of 1.3 to 1.6 having a first main face (11) called the first surface; and
- an electrode, carried by the glazing substrate on the same side as the first surface (11), which electrode comprises a layer arranged in a grid (2, 20) called the metal grid, which grid is made of metal(s) having a sheet resistance smaller than 20 Ω/□ and has a thickness e2 of at least 100 nm, the grid being formed from strands (20), the strands having a width A smaller than or equal to 50 µm and being separated by an inter-strand distance B smaller than or equal to 5000 µm, the strands being separated by a plurality of electrically insulating non-electrically conductive fields (31) of refractive index higher than 1.65,
**characterized in that**, on the same side as the first surface (11), the carrier comprises:
- an electrically insulating light extraction layer (41 to 42) under the metal grid (2); and
- an electrically insulating layer (3) partially structured in its thickness, this layer (3) being of given composition and of refractive index n₃ of 1.7 to 2.3, and being located on the light extraction layer, which partially structured layer is formed:
- from a region (31), located furthest from the light extraction layer, structured with cavities containing the metal grid, this region (31) containing the non-electrically conductive fields; and
- from another region (30), called the low region, located under the metal grid and on the light extraction layer,
and **in that** the grid is set back from the surface called the high surface (31') of the non-electrically conductive fields (31) and the separation H between the high surface (31') and the surface of the metal grid (2) is larger than 100 nm, H being measured between the middle of the surface of the strands and the high surface, and **in that** the strands (2) have along their length a central zone (21) between lateral zones (22, 22') that are flush with the high surface (31').

2. Electrically conductive carrier (100 to 200) according to one of the preceding claims, **characterized in that** H is larger than 150 nm and preferably smaller than 500 nm.

3. Electrically conductive carrier (100 to 200) according to one of the preceding claims, **characterized in that** the surface of the strands (20) is devoid of protuberances of height larger than 10 nm along the interior edges of the lateral zones (22, 22').

4. Electrically conductive carrier (100 to 200) according to one of the preceding claims, **characterized in that** the metal grid (2, 20) is obtained by electroless deposition and preferably by silvering.

5. Electrically conductive carrier (100 to 200) according to one of the preceding claims, **characterized in that** the surface roughness of the central zone (21) is higher than the surface roughness of the lateral zones (22, 22'), and the Rq roughness parameter of the lateral zones (22, 22') is at most 5 nm.

6. Electrically conductive carrier (100 to 200) according to one of the preceding claims, **characterized in that** the lateral zones (22, 22') are of width L1, L1 being larger than the height e_{c} of the cavities and L1≤2e_{c}.

7. Electrically conductive carrier (100 to 200) according to one of the preceding claims, **characterized in that** the metal grid (2, 20), which is preferably made of silver, has a coverage T smaller than 25% or smaller than 10% and even than 6%.

8. Electrically conductive carrier (100 to 200) according to one of the preceding claims, **characterized in that** the thickness e₂ of the metal grid (2, 20) is smaller than 1500 nm, preferably in a range extending from 100 nm to 1000 nm and in particular in a range extending from 200 nm to 800 nm, and the width A is smaller than 30 µm and preferably in a range extending from 1.5 µm to 20 µm.

9. Electrically conductive carrier (100 to 200) according to one of the preceding claims, **characterized in that** the one or more materials of the metal grid (20) are chosen from the group formed by silver, copper, nickel and alloys based on these metals, and is preferably based on silver.

10. Electrically conductive carrier (100 to 200) according to one of the preceding claims, **characterized in that** the cavities (32, 32'), of height e_{c} larger than 200 nm, are bounded by flared flanks (32) that get further apart with distance from the glazing substrate, with a horizontal distance L larger than e_{c} and with L≤2e_{c}.

11. Electrically conductive carrier (100 to 200) according to one of the preceding claims, **characterized in that** the structured region (31), and preferably the low region (30), does not contain any scattering particles.

12. Electrically conductive carrier (100 to 200) according to one of the preceding claims, **characterized in that** the partially structured layer (3) is made of a vitreous material, preferably an enamel.

13. Electrically conductive carrier (100 to 200) according to one of the preceding claims, **characterized in that** the substrate (1) is preferably made of mineral glass, and the light extraction layer comprises an additional scattering layer (41) the constituents of which comprise a vitreous material, preferably an enamel, and scattering elements (4', 4"), and the composition of the partially structured layer (3) comprises a vitreous material, preferably an enamel, the composition of which is especially identical to that of the material of the additional scattering layer, and/or **in that** a scattering first surface of the substrate (42), which is preferably made of mineral glass, forms part or even is the light extraction layer, and the composition of the partially structured layer (3) comprises a vitreous material, preferably an enamel.

14. Electrically conductive carrier (100 to 200) according to one of the preceding claims, **characterized in that** an electrically conductive coating (5) covers, preferably directly, the high surface (31') and the metal grid (2) that is preferably made of silver, this electrically conductive coating especially having a thickness e₅ smaller than or equal to 500 nm, a resistivity ρ₅ smaller than 20 Ω.cm and higher than the resistivity of the metal grid, and a refractive index n₅ of at least 1.55.

15. Electrically conductive carrier (100 to 200) according to the preceding claim, **characterized in that** the electrically conductive coating (5) comprises a mineral layer of refractive index nₐ comprised between 1.7 and 2.3, which layer is preferably smaller than 150 nm in thickness and made of a transparent electrically conductive oxide preferably based on indium tin oxide or zinc oxide.

16. Electrically conductive carrier according to either of Claims 14 and 15, **characterized in that** the electrically conductive coating comprises, at least as the last layer furthest from the substrate, an organic layer of submicron-sized thickness made of electrically conductive polymer(s) such as PEDOT or PEDOT:PSS of refractive index n_{b} of at least 1.55.

17. Electrically conductive carrier according to either of Claims 14 and 15, **characterized in that** it comprises an organic light-emitting system deposited on the electrically conductive coating (5), optionally including a hole transport layer HTL or a hole injection layer HIL.

18. Organic light-emitting device incorporating an electrically conductive carrier (100 to 200) according to any one of the preceding claims, the electrode with the metal grid forming the electrode called the lower electrode, closest to the substrate.

19. Process for manufacturing the electrically conductive carrier (100 to 200) according to one of the preceding electrically conductive carrier claims, **characterized in that** it comprises the following steps in this order:
- providing the substrate comprising:
- the light extraction layer (4), preferably formed by the scattering first surface of the substrate and/or formed by an additional scattering layer on the first surface of the substrate; and
- on the light extraction layer, what is called a high-index layer (3a) made of the composition of refractive index n₃, which layer (3a) preferably contains no scattering particles, said high-index layer preferably planarising the light extraction layer;
- forming cavities in the high-index layer (3a), thus forming the partially structured layer (3), this cavity-forming step comprising:
- producing, on the high-index layer (3a), a discontinuous masking layer containing a given arrangement of through-apertures having flanks; and
- wet etching the high-index layer (3a) through the through-apertures in the masking layer, the flanks of the masking layer jutting out relative to the flanks of the cavities and thus defining surface portions, called internal surfaces (62, 62'), of the masking layer, facing the cavities;
- forming the metal grid (2), this grid-forming step comprising partially filling the cavities by preferably electroless wet deposition of a first metal of the grid, this first metal being deposited on the bottom of the cavities, on the flanks of the cavities and entirely on the internal surfaces (62, 62') of the masking layer (60), thus forming the lateral zones of the strands (22, 22'), these zones being flush with the high surface and less rough than the central zones of the strands (21); and
- removing the masking layer.

20. Process for manufacturing the electrically conductive carrier (100 to 200) according to the preceding claim, **characterized in that** removing the masking layer does not create protuberances of height of at least 10 nm on the surface of the metal grid.

21. Process for manufacturing the electrically conductive carrier (100 to 200) according to one of the preceding claims, **characterized in that** the wet deposition is silvering and preferably the grid (2) is a monolayer.

22. Process for manufacturing the electrically conductive carrier (100 to 200) according to one of the preceding process claims, **characterized in that** the masking layer (60) is a photoresist.

23. Process for manufacturing the electrically conductive carrier (100 to 200) according to one of the preceding process claims, **characterized in that** it comprises after the masking layer has been removed, deposition by cathode sputtering of an electrically conductive coating (5) based on ITO or doped zinc oxide, or wet deposition of a polymeric electrically conductive coating.

24. Process for manufacturing the electrically conductive carrier (100 to 200) according to one of the preceding process claims, **characterized in that** the high-index layer (30) comprises an enamel especially obtained from a first glass-frit-based composition, and preferably the additional scattering layer comprises an enamel obtained from a second glass-frit-based composition that is preferably identical to the first composition except that it comprises scattering particles.

25. Process for manufacturing the electrically conductive carrier (100 to 200) according to one of the preceding process claims, **characterized in that** it comprises, before the electrically conductive coating is deposited, a step of heating to a temperature above 180°C, preferably comprised between 250°C and 450°C, in particular between 250°C and 350°C, for a length of time preferably comprised between 5 minutes and 120 minutes, in particular between 15 and 90 minutes, and/or **in that** it comprises deposition of a mineral, preferably ITO, layer to form the electrically conductive coating and subsequent heating to a temperature above 180°C, preferably comprised between 250°C and 450°C, in particular between 250°C and 350°C, for a length of time preferably comprised between 5 minutes and 120 minutes, in particular between 15 and 90 minutes.
